# EUROPEAN PATENT SPECIFICATION

(11) **EP 2 671 091 B1**
(45) Date of publication and mention of the grant of the patent: **24.12.2014**
(21) Application number: 11704564.1
(22) Date of filing: 03.02.2011
(51) Int. Cl.: G01R 33/09, G01R 33/00

(54) **MAGNETIC FIELD SENSING DEVICE**
MAGNETFELDSENSOR
DISPOSITIF SENSIBLE AU CHAMP MAGNÉTIQUE

(43) Date of publication of application: 11.12.2013
(73) Proprietor: Sensitec GmbH, 35633 Lahnau (DE)
(72) Inventor: LOREIT, Uwe, 35580 Wetzlar (DE); WEBER, Sebastian, 35584 Wetzlar (DE)
(74) Representative: Spachmann, Holger
(86) International application number: PCT/EP2011/051585
(87) International publication number: WO 2012/103950

(56) References cited:
- DE-A1- 4 327 458
- US-A- 5 247 278
- US-A- 5 952 825
- US-A1- 2009 108 841

## Description

### TECHNICAL FIELD

The present invention relates to a magnetic field sensing device for sensing a direction and magnitude of an external magnetic field.

### BACKGROUND ART

The AMR effect (Anisotropic Magneto Resistance Effect) is used in a wide array of sensors, especially for the measurement of the earth's magnetic field, as an electronic compass or for electric current measurement (by measuring the magnetic field created around the conductor), for traffic detection and for linear position sensing and angle sensing. Typically, AMR magnetic field sensing devices comprise magnetic field sensing elements utilizing the AMR effect, which is the property of a conductive material to change the value of its electrical resistance when an external magnetic field is applied. Using a Wheatstone bridge configuration enables a highly sensitive measurement of resistance variations of the AMR sensitive bridge resistors. Since more and more highly compact electronic devices, such as navigation systems, pulse watches, speedometers, mobile computers and similar electronic products, comprise a magnetic field sensor, the need for highly integrated and small magnetic field sensor chips arises.

It is well known that sensitivity of an AMR sensor chip can be increased by introducing a magnetic field flipping mechanism, wherein an internal magnetization of each AMR magnetic sensing element is periodically flipped, such that a differential measurement of a single component of a magnetic field can be performed. Therefore, typical sensor chips comprise a magnetic flip conductor for generating a magnetic flipping field, wherein the flip conductor is integrated in a single chip layer of the AMR sensor chip. Many electric devices incorporating a magnetic field sensor chip are powered by batteries or accumulators with low capacity. Thus it is desirable that said flipping mechanism should not consume too much electric power, whereby high flipping frequency rates should be achieved for enhancing the resolution and accuracy of the magnetic field measurement. Furthermore, since the size of the flip conductor of conventional designs dominates the overall dimensions of the magnetic field sensor chip it is further desirable to miniaturize the flip conductor design, which helps to decreases inductance and in consequence increases flipping rate.

From US 5,247,278 A, a magnetic field sensing device is known, wherein a flip conductor is formed with a spiral design and covers the main part of the area of the magnetic field sensor chip. The layout of the flip conductor determines the size of the sensor chip. The flip conductor is arranged on a single layer and is separated from the Wheatstone bride layer and from the chip substrate by dielectric insulating layers. Arranging a comparatively large flip conductor on a single layer of a sensor chip results in a comparatively high electric energy consumption in the generation of a sufficiently large magnetic flipping field for flipping the internal magnetization of the magnetic field sensing elements, occupies a large part of the chip area, consumes a significant amount of electric energy and exhibits a high inductance, such that only comparatively low flipping frequencies can be attained which limit the temporal resolution of the magnetic field sensing.

US 5 952 825 teaches a similar magnetic field sensing device whereby a spiral-formed flip conductor is arranged on a single layer. Furthermore two also spiral-formed compensation conductors are arranged on a separate layer between the flip conductor layer and the Wheatstone bridge layer. The overall size of the chip is large in comparison to the size of the Wheatstone bridge resistors, whereby an increased inductance and stray fields causes an increased consumption of electric energy.

DE 43 27 458 A1 reveals a magnetic field sensing device comprising a Wheatstone bridge configuration wherein the single AMR sensitive bridge resistors have a tapered form with an elliptic outline with Barber pole structured electric guiding elements. Finally US 2009 0108841 A1 describes a two-axis magnetic field sensing device comprising two Wheatstone bridge resistor arrangement and multiple compensation conductor arrangements.

A problem encountered with the magnetic field sensing devices known from the state of the art resides in the aspect that the magnetic field conductor is relatively large with respect to the AMR resistor configuration, consumes a relatively high amount of electric energy and does not allow to increase a flipping frequency, such that a higher miniaturization and better resolution of the magnetic field sensing device is limited. It is therefore desirable to provide an enhanced magnetic field sensing device, which enables higher integration, smaller chip size, lower power consumption, higher temporal resolution and sensitivity of the magnetic field sensing.

### DISCLOSURE OF THE INVENTION

The object of the present invention is achieved by a magnetic field sensing device according to claim 1.

The invention suggests a magnetic field sensing device comprising several functionally different layers, wherein a Wheatstone bridge layer comprises at least two resistors of a Wheatstone bridge. Each resistor of the Wheatstone bridge comprises at least one magnetic field sensing element as a subresistor. A flip conductor layer comprises at least one flip conductor for flipping the internal magnetization state of each magnetic field sensing element. The flip conductor comprises a plurality of conductor stripes being arranged on at least two different flip conductor sublayers of said flip conductor layer, wherein the conductor stripes of the sublayers are electrically coupled with each other through via connections, i. e. so-called vias. Thus, the magnetic field sensing device suggests a design of a sensor chip, wherein the flip conductor is arranged on at least two sublayers which can lie on top of each other or which may sandwich the Wheatstone resistors. Such a design requires nearly half the size of a conventional magnetic sensor chip area. This results from the multilayered structure of the flip conductor being arranged on at least two sublayers. The three-dimensional structure reduces chip size outside of the area, where the magnetic field sensing elements are located, thus making the overall size of the sensor chip more compact. Furthermore, due to the compact design, magnetic stray fields can be decreased and inductance can be reduced. The magnetically active conductor stripes adjacent to the magnetic field sensing elements can be designed with a U-shape, a meandering shape or a spiral shape and can exert equivalent or superior effects on the flipping mechanism as existing flip conductor structures. The basic concepts of the flipping mechanism follow conventional designs, i. e. flipping the orientation of the magneto-resistive stripes of each resistor relative to the conductor stripes of a flip conductor sublayer close to the magnetic sensing elements. As a result, the magnetic field sensing elements of the resistor arrangement can be located more closely to each other, such that magnetic field sensing elements are rendered more homogeneous and material impurities and fabrication defects affect two or more resistors equally, resulting in the following improvements:
- improved linearity of the R/θ relation curve, whereby θ is an angle of an external magnetic field to be measured with respect to an alignment of a magnetic field sensing element and R is the electric resistance of said element;
- decreased sensitivity of temperature changes and fabrication variations;
- reduced offset voltage V_{off} of the Wheatstone bridge configuration;
- more compact design and smaller chip size;
- decreased inductance of flip coil due to reduced magnetic stray field;
- increased sensing frequency limit; and
- decreased flipping voltage, flipping current /_{F} , and energy consumption.

In general, magnetically active conductor stripes which are designed for providing a magnetic flipping field or magnetic flipping impulse and conductor stripes for electrically conducting said active conductor stripes can be located in any arbitrary form on both sublayers. According to a preferred embodiment, the flip conductor can comprise a first set of magnetically active conductor stripes for providing a magnetic flipping field of an associated magnetic field sensing element. The first set of conductor stripes can be arranged on a first flip conductor sublayer facing a Wheatstone bridge layer side. Furthermore, the magnetic field sensing device can comprise at least one second set of conductor stripes for providing an electrical connection of said first set of conductor stripes, being arranged on at least one second flip conductor sublayer. In this way, both sublayers are designed for a specific technical purpose: the first layer comprises a first set of conductor stripes for generating the magnetic flipping field and the second layer comprises a second set of conductor stripes for connecting the first set of conductor stripes, such that a flipping current can generate a magnetic flipping field which flips the internal magnetization state of each magnetic sensing element. Preferably, the magnetically active first sublayer is located close to the magnetic field sensing elements of the resistors of the Wheatstone bridge, such that a small current can generate a magnetic flipping field being sufficient for flipping the internal magnetic state of the subresistors. Decreasing the distance between the first set of conductor stripes and the magnetic field sensing element reduces energy consumption of the flipping process.

In general, the flip conductor provides a magnetic field in parallel or anti-parallel to the internal magnetization of said magnetic field sensing element. For instance, the conductor stripe can be designed as a solenoid or a cylindrical coil. According to a preferred embodiment and following the aforementioned embodiment, said first set of conductor stripes is essentially oriented perpendicular with respect to a longitudinal alignment of said magnetic field sensing element, and said second set of conductor stripes is essentially oriented in parallel with respect to said longitudinal alignment of said magnetic field sensing element. A conductor stripe generates a magnetic field which is perpendicular to the current flow along the stripe. Therefore, a conductor stripe being oriented perpendicular with respect to the length direction of a magnetic field sensing element can generate a magnetic flipping field in parallel or anti-parallel to the internal state of the magnetic flip element for electrically connecting the perpendicular conductor stripes to the parallel-oriented stripes of said second sublayer contact of said first set of perpendicular conductor stripes. The electric connection between both sublayers is created by vias or bonding wires. In this way, a compact and efficient conductor coil arrangement with reduced geometric dimensions can be provided.

In general, the conductor stripes of said first flip conductor sublayer can be single stripes being oriented preferably perpendicular to an internal magnetization direction of associated magnetic field sensing elements. Alternatively, said conductor stripes can be U-shaped, spiral-shaped or meandering-shaped and can also comprise regions being parallel-oriented with respect to said internal magnetization direction. Such single, parallel-oriented conductor stripes, U-shaped, spiral-shaped or meandering-shaped conductor stripes can form fingers, such that multiple non-connected conductor stripes can engage with each other. According to the foregoing embodiment, said first set of conductor stripes can comprise an interdigital arrangement of said perpendicularly oriented conductor strips for providing a magnetic flipping field for a center part of said magnetic field sensing element and perpendicular conductor strips for providing a magnetic flipping field for end parts of said magnetic field sensing element. An interdigital arrangement, wherein conductor stripes with an opposing direction of current flow neighbouring each other, provides a compact design with reduced inductance and minimized magnetic stray field. The parallel-oriented conductor stripes of said second sublayer connect the fingers of the first set of conductor stripes.

According to a preferred embodiment, said first set of conductor stripes can be designed and arranged so that an increased magnetic flipping field can be provided at both end parts of each magnetic field sensing element with respect to a magnetic flipping field provided for a center part of said magnetic field sensing element. Flipping the magnetic field sensing elements is ensured by applying a comparatively strong magnetic flipping field to both ends of a magnetic field sensing element and a reduced magnetic flipping field to the center part of the magnetic field sensing element. An increased magnetic flipping field can be provided at both end parts by increasing current density at the end parts with respect to the center parts of a magnetic flipping current flowing through the flip conductor. For instance, arranging flip conductor stripes with reduced width at the end parts and with increased width at the center part of the magnetic field sensing elements or designing a flip conductor stripe with a conductance profile, such that a flipping current density is increased at the end parts of a magnetic field sensing element, provides a magnetic flipping field for a stable and reliable flipping of the internal magnetization state of the magnetic field sensing element.

According to a further preferred embodiment which is advantageous in combination with the foregoing embodiment, at least one conductor stripe of said first set of conductor stripes can comprise at least one current distribution element being designed to provide a current distribution, such that a homogeneous magnetic flipping field can be excited in a center part of said magnetic field sensing element, preferably a conductance profile or a non-conducting area, especially a recess, whereby preferably said conductor stripe is adapted for flipping the internal magnetization state of the center part of said magnetic field sensing elements. The current distribution element is designed for providing a homogeneous current distribution in the center part of a magnetic sensing element. Due to its highly compact design, the flip conductor comprises a plurality of rough edges. The current distribution element can be a hole, a recess or a non-conducting part of said first set of conductor stripes for providing a homogeneous distribution of the magnetic flipping current, preferably in a center part of a magnetic field sensing element. In this way, a homogeneous magnetic flipping field can be provided for the center part, and optionally the current distribution element can be designed to provide an increased magnetic field at the end parts of the magnetic field sensing element. If the conductor stripes consist of a not perfectly conducting material, the current distribution material can also comprise a conductance profile forcing a homogeneous current distribution in a center region and optionally an increased current distribution at the end parts of a magnetic field sensing element.

According to a preferred embodiment, said resistor can comprise at least two magnetic field sensing elements as subresistors, wherein each magnetic field sensing element comprises a Barberpole structure with a positive or a negative Barberpole alignment depending on its arrangement with respect to a current flow direction of the associated perpendicular conductor stripe of the flip conductor. In this way, the conductor stripes of an adjacent and magnetically active flip conductor sublayer sets a direction of magnetization of half the number of the magneto-resistive stripes (magnetic field sensing element) of each resistor in a Wheatstone bridge network in one direction and half the number in another direction, such that an improved linearity and enhanced sensitivity of the sensor device can be achieved. For instance, a resistor comprises at least two magnetic field sensing elements, a first element with a positive Barberpole arrangement and a second with a negative Barberpole arrangement in a series connection. Both elements are arranged with respect to their corresponding magnetically active flip conductor stripes, such that their internal magnetizations can be flipped opposing to each other. Thus, an Uₐ/H-relation curve of the Wheatstone bridge is linearized and accuracy and sensitivity are improved.

According to the foregoing embodiment, the subresistors of said at least two resistors of said Wheatstone bridge layer can be arranged in an interdigital manner. In detail, each resistor comprises a series connection of a plurality of magnetic field sensing elements. The magnetic field sensing elements of each resistor are arranged in a meandering form, whereby two series-connected elements form a "finger" and are arranged side by side. A gap is formed between two neighboring fingers of a first resistor, such that a finger of a second resistor can be interposed between said two fingers of the first resistor. In this way, fingers of a first and a second resistor can be arranged in an interdigital manner, resulting in a compact arrangement and in similar material properties and characteristics of both resistors. As a result, the overall size of the sensor chip can be reduced and linearity, accuracy and sensitivity can be improved.

According to a preferred embodiment, both longitudinal end parts of said magnetic field sensing element can have a tapered form, preferably an elliptic form. A tapered form, for instance a narrowed or attenuated elliptic for the end parts of a magnetic field elements, improves the electrical connection of said elements and reduces the strength of a magnetic flipping field for flipping the internal state of the element. In this way, overall energy consumption for the flipping mechanism can be reduced.

In general the Wheatstone bridge layer can be arbitrarily arranged with respect to said first and second flip conductor sublayer. According to a preferred embodiment, said bridge resistors can be arranged on a Wheatstone bridge layer beneath and favourably adjacent to said first flip conductor sublayer. The Wheatstone bridge layer can preferably also be arranged within said second flip conductor sublayer, whereby conducting stripes of said second flip conductor sublayer and magnetic field sensing elements of said Wheatstone bridge are arranged on the same layer. Alternatively the Wheatstone bridge layer can be sandwiched between said first and said second flip conductor sublayer, wherby the magnetic field sensing elements of the Wheatstone bridge are disposed between said first and second sublayer. It is also possible to arrange the Wheatstone bridge layer on top of said first flip conductor sublayer. The first flip conductor sublayer should be arranged close to the magnetic field sensing elements of the Wheatstone bridge for reliably flipping its internal magnetization. The magnetic field sensing elements of the Wheatstone bridge can favourably be located within the second sublayer, whereby the second set of conductor stripes is essentially oriented in parallel to the magnetic field sensing elements, which reduces the volume of the chip, shortens the length of the conductor stripes and reduces inductance and improves coupling of the magnetic field sensing elements with the magnetic flipping field of the magnetically active conductor stripes of the flip conductor. A magnetic field sensing element comprise an AMR material stripe, e.g. permalloy and attached thereto a barberpole structure of highly conducting material aligned in an angle of preferably 45° with respect to the alignment of the AMR material stripe. During processing of the barberpole structure vias for connecting the second set of flip conductor stripes and the first set of flip conductor stripes can be manufactured simultaneously using the same material as for the barberpole structure.

According to a preferred embodiment, the magnetic field sensing device can comprise a compensation conductor for generating a magnetic compensation field to compensate an external magnetic field, wherein said compensation conductor is disposed on at least one compensation conductor layer, preferably on top of said Wheatstone bridge layer and adjacent to and/or staggered with said flip conductor layer. A compensation conductor can also generate a magnetic field, but in contrast to a flip conductor, not in parallel but rather perpendicular to the length orientation of a magnetic field sensing element. The compensation conductor can generate a magnetic field being parallel to a component of the external magnetic field to be sensed, such that an external magnetic field can be compensated. The magnetic compensation field can eliminate or correct an external magnetic field and can be used for biasing the magnetic field sensing device. It can be advantageous to arrange the Wheatstone bridge layer between said flip conductor layer and said compensation conductor layer, such that magnetically active parts of each layer can be arranged close to the magnetic field sensing element. As a result, a magnetic flipping field as well as a magnetic compensation field can be generated with reduced electric energy. Compensation conductor layer and flip conductor layer can comprise two or more sublayers. It can be advantageous that sublayers of both conductor layers are staggered on each other, such that sublayers of both layers are alternatively arranged on each other.

In addition to the foregoing embodiment, it is advantageous to arrange multiple conductor stripes of said compensation conductor on at least two different compensation conductor sublayers of said compensation conductor layer. The conductor stripes of the different sublayers can be electrically coupled through vias with each other, such that a first set of compensation conductor stripes for providing a magnetic compensation field is arranged on said first compensation conductor sublayer, and a second set of compensation conductor stripes for providing an electrical connection of said first set of compensation conductor stripes is arranged on said second compensation conductor sublayer. Said first set of compensation conductor stripes can be arranged above and adjacent to said Wheatstone bridge layer and underneath said first compensation conductor sublayer. Preferably, the magnetically active conductor stripes of the first compensation conductor sublayer are placed close to the resistors of the Wheatstone bridge layer. Furthermore it is favourable to place the second compensation conductor sublayer remote from the Wheatstone bridge layer such that a magnetic field generated by the compensation conductor stripes of the second set of compensation conductor stripes does not adversely affect the compensation magnetic field of the Wheatstone bridge resistors. Alternatively the second set of compensation conductor sublayer can be located beneath the Wheatstone bridge layer such that the Wheatstone bridge layer is sandwiched between the first and second set of compensation conductor sublayers, whereby the magnetic field generated by the conductor stripes of the second set of compensation conductors stripes contributes to the compensation magnetic field generated by the first set of compensation conductor stripes. In a preferred embodiment a set of conductor stripes of the second flip conductor sublayer is arranged in parallel with AMR material stripes representing magnetic field sensing elements on a surface of a chip substrate. On top of this layer a set of conductor stripes of the first compensation conductor sublayer is arranged. Subsequent a set of flip conductor stripes of the first flip conductor sublayer is arranged and hereafter on top of the chip layer arrangement a set of compensation conductor stripes of the second compensation conductor sublayer is arranged. The sublayers can be contacted by vias. Thus a staggered arrangement of alternating sublayers of compensation conductor stripes and flip conductor stripes provide a compact, highly sensitive and energy efficient magnetic field sensing device. This embodiment suggests transferring the aforementioned concept of a multiple flip conductor layer arrangement to a multiple compensation conductor layer arrangement. In this way, advantages and improvements with respect to the flip conductor concept also hold for the compensation conductor.

According to a preferred embodiment, at least a part of said flip conductor and/or said compensation conductor is arranged essentially in a U-shape, a spiral shape and/or a meandering shape. All of these arrangements comprise perpendicularly and parallel-oriented elements which can be assigned to magnetically active and electrically connecting conductor stripes of the flip conductor and/or the compensation conductor. All arrangements provide magnetically active conductor stripes with opposing magnetic fields and can be implemented in a compact form. These arrangements can also be combined, i.e. a sublayer can comprise conductor stripes being U-shaped and spiral-shaped, U-shaped and meandering-shaped, or otherwise.

According to a preferred embodiment, the material of said flip conductor and/or said compensation conductor is highly conductive, preferably comprising copper, aluminum, silver, gold or an alloy thereof, and is preferably identical to the material forming the Barberpole structure. A highly conductive conductor can generate a high current even with a low voltage of a battery-driven device, such that a sufficiently large magnetic field can be produced. Using an identical material for the Barberpole structure and the conductor stripes reduces manufacturing complexity, whereby the Barberpole structure and the conductor stripes can be manufactured simultaneously.

In general, a single flip conductor is provided for simultaneously flipping all magnetic field sensing elements of the Wheatstone bridge. According to a preferred embodiment, two or more electrically separated flip conductors for independently flipping a magnetization state of at least one magnetic field sensing element of a bridge resistor can be provided. Two independent flip conductors allow the independent flipping of half of the magnetic field sensing elements. Both flip conductors can generate four different flip states of the magnetic field sensing elements of a Wheatstone bridge resistor, such that the sensitivity of the Wheatstone bridge can be switched on or off. This allows the measuring of the offset voltage of the bridge, as well as performing a self-test of the bridge. The offset voltage can be used to further improve accuracy of the magnetic field sensing device.

The embodiments listed above comprise a number of non-limiting examples. For instance concepts of the flip conductor arrangement and compensation conductor arrangement can be combined, merged with or transferred to each other. A resistor can comprise at least one or multiple series-connected magnetic field sensing elements, preferably AMR stripes. The Barberpole arrangement of the magnetic field sensing elements of each resistor can be identical or alternating, depending on the arrangement with respect to the flip conductor. The flip conductor sublayer can be stacked or can sandwich the Wheatstone bridge layer. Preferably, the Wheatstone bridge layer is arranged within the second sublayer of the flip conductor. A compensation conductor layer can be stacked on top of or underneath a flip conductor layer. Preferably, the flip conductor layer and the compensation conductor layer sandwich said Wheatstone bridge layer.

### BRIEF DESCRIPTION OF DRAWINGS

Hereinafter, the invention will be described in greater detail with reference to the attached drawings. These schematic drawings are used for illustration only and do not in any way limit the scope of the invention. In the drawings:
- **Fig. 1**: schematically shows the AMR concept and resistance dependency with respect to an angle of an external magnetic field of a magnetic field sensing element without Barberpole structure;
- **Fig. 2**: shows the effect of a Barberpole structure with respect to **Fig. 1****;**
- **Fig. 3**: shows a schematic view of a Wheatstone bridge arrangement of a magnetic field sensing device of the state of the art without flip conductor;
- **Fig. 4**: shows different schematical views of a magnetic field sensing device with flip conductor, wherein the Wheatstone bridge resistor consists of a single magnetic field sensing element, multiple magnetic field sensing elements and multiple flip conductors;
- **Fig. 5**: shows different magnetic field sensing devices with flip conductor arrangements of a state of the art;
- **Fig. 6**: schematically shows a first embodiment of a magnetic field sensing device with a multilayered flip conductor;
- **Fig. 7**: shows single sublayers of the flip conductor layer of **Fig. 6****;**
- **Fig. 8**: shows a second embodiment of a magnetic field sensing device with an interdigital arrangement of magnetic field sensing elements;
- **Fig. 9**: schematically shows another embodiment of a magnetic field sensing device with a meandering-shaped and U-shaped flip conductor arrangement of a first sublayer;
- **Fig. 10**: displays single sublayers of the flip conductor layer of **Fig. 9****;**
- **Fig. 11**: schematically shows a sublayer arrangement with a U-shaped flip conductor arrangement of another embodiment of a magnetic field sensing device;
- **Fig. 12**: shows another embodiment of a magnetic field sensing device with a flip conductor and a compensation conductor arrangement;
- **Fig. 13**: displays single sublayers of the flip conductor layer and the compensation conductor layer of **Fig. 12****;**
- **Fig. 14**: shows a schematic view of a three-dimensional arrangement of flip conductor layer, compensation conductor layer and Wheatstone bridge layer of another embodiment of a magnetic field sensing device.

### DETAILED DESCRIPTION OF PREFERRED EMBODIMENTS OF THE INVENTION

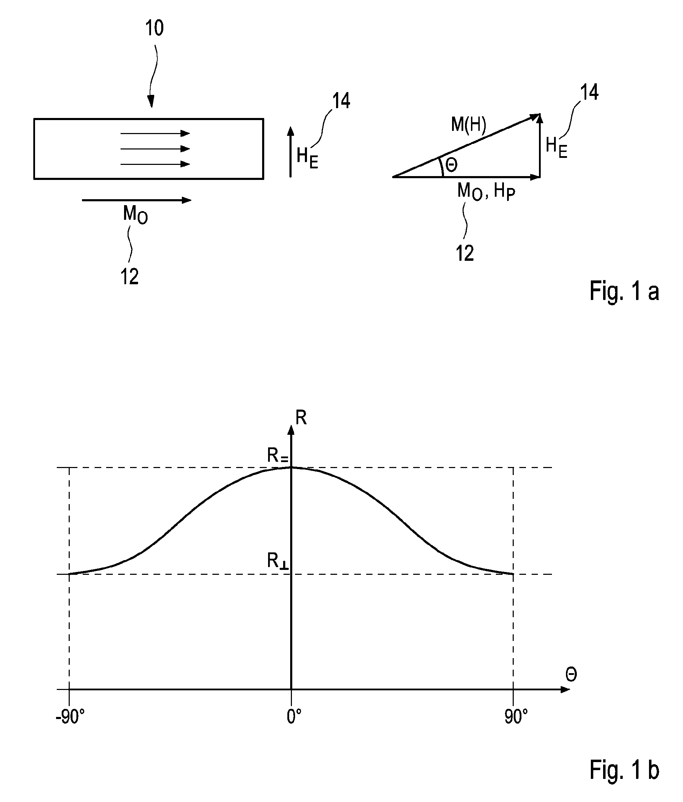

**Figs. 1a** and **1b** schematically show the AMR concept and resistance dependency with respect to an angle of an external magnetic field 14 of a magnetic field sensing element 10 without Barberpole structure 16. Magnetoresistance is the property of a material to change the value of its electrical resistance when an external magnetic field is applied to it. The so-called anisotropic magnetoresistance (AMR) is the property of a magnetic field sensing element 10, in which an electrical resistance depends on the angle θ between the direction of electrical current and orientation of a magnetic field *M*. This effect can preferably be observed in a narrow (*w*), thin (*t*) and long (*I*) sheet of permalloy where *l*>>*w*>>*t* holds. Permalloy is an alloy of 81 % Ni and 19% Fe. The electrical resistance *R* of the element 10 has its maximum *R*=when the electrical sensing current is in parallel with the direction of a magnetic field *M* and has its minimum *R*_{⊥} when the magnetic field *M* is perpendicular to the current's direction. The effect is caused by a distortion of the electron-spin-alignment of the atoms due to the field *M*. The permalloy magnetic field sensing element 10 has an internal magnetization *M₀* 12, which is typically aligned to the longitudinal direction of the AMR sensing element and to the electric current flowing through the sensing element 10. In the following it is assumed that the magnetization *M* is split into a component *H*_{P} parallel to the internal magnetization *M₀* and to the sensing current, and *H*_{E} 14 being perpendicular to the sensing current and internal magnetization *M*₀ 12, whereby it is further assumed that |*M*₀|» |*H*_{P}| holds, such that *H*_{P} can be neglected in the following. Considering an electrical current parallel to the magnetization *M*₀ 12 the following relation holds: *R*=*R*_{⊥}+(*R*₋ -*R*_{⊥})cos²*(*Θ*)* with arctan(Θ) as ratio of magnitude of external perpendicular magnetic field component *H*_{E} 14 and internal magnetization *M*₀ 12, which is depicted in **Fig. 1b****.** The resistance sensitivity of the sensing element 10 is maximized, if |*H*_{E}| equals |*M*₀| (Θ∼45°), and is minimized, if |*M*₀|» |*H*_{E}| *and* |*M*₀|« |*H*_{E}| ((Θ∼0° or 90°).

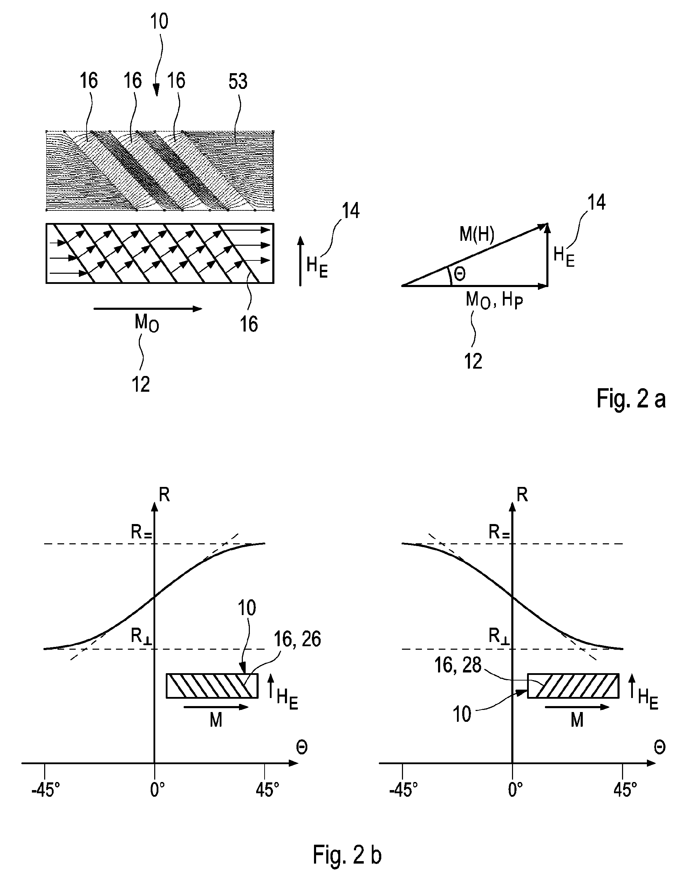

**Figs. 2a** and **2b** display a further developed magnetic field sensing element of **Fig. 1** with a Barberpole structure 16 for enhancing the external magnetic field sensitivity, such that a maximized resistance sensitivity is reached in the case that |*M*₀|» |*H*_{E}| ((Θ∼0°). Starting from an magnetoresistive stripe element of **Fig. 1****,** it is desirable to have a magnetic field sensor 10 with an ohmic resistance being sensitive to small magnetization variations of the sensing field *H*_{E} against the internal magnetization *M₀.* Since the *R*/Θ relation curve with Θ = arctan(*H*_{E} /*M*₀) is flat for small *H*_{E} values, typical AMR sensors are equipped with a so-called barberpole structure 16. The barberpole structure 16 comprises small highly conductive stripes made from platinum, copper, aluminum, silver or gold, which are attached to the magnetizable material (e.g. permalloy) in a 45° angle with respect to the current flow, thus forcing a 45° inclined current 53 flowing through the element 10, as shown in **Fig. 2a****.** In this way, the *R*/Θ relation curve is shifted towards a linear region where small *H*_{E} variations lead to a linear resistance change, such that *R* = *R_{⊥}* +(*R_{_}* -*R*_{⊥})cos²*(*Θ±45°*)* holds. As can be seen in **Figs. 2a and 2b****,** the slope of the *R*/Θ relation curve depends on the angle of the Barberpole alignment and the direction of the internal magnetization field *M*₀ with respect to the sensing field *H*_{E}. As can be seen from above, the slope of the resistance change depends on the direction of the Barberpole angle 26, 28 and the alignment of the magnetization *M*₀ with respect to the sensing field *H*_{E} 14.

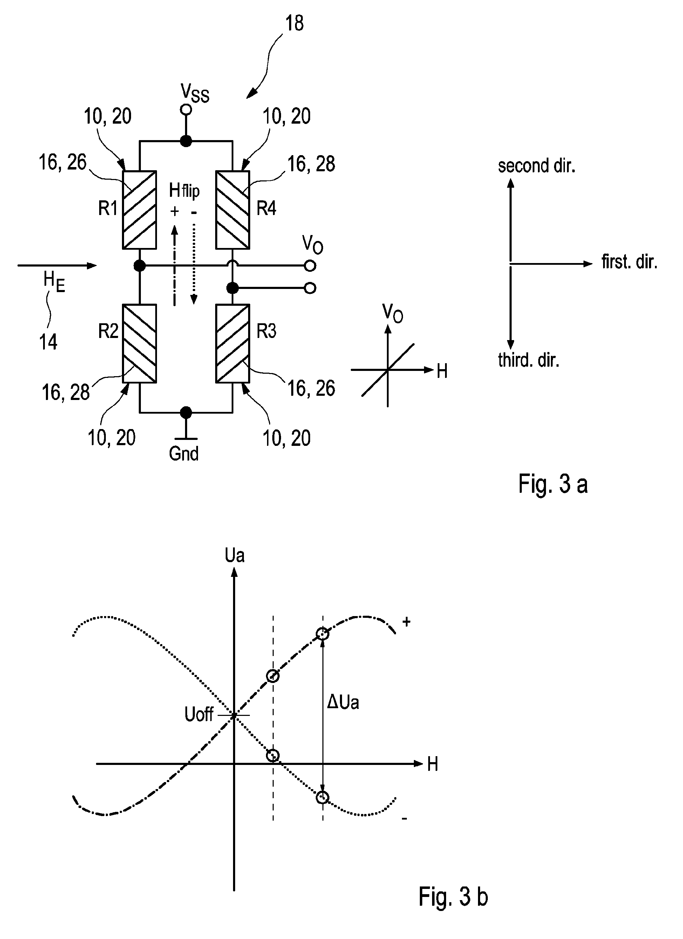

**Fig. 3** shows a schematical view of a Wheatstone bridge arrangement 18 of a magnetic field sensing device for sensing a magnitude of a magnetic field component *H*_{E} 14. The Wheatstone bridge 18 comprises four magnetic field sensing elements 10 as bridge resistors 20 with Barberpole structures 16 having positive and negative angles 26, 28. **Fig. 3b** displays an *U*ₐ/*H* relation of the Wheatstone bridge 18, when a voltage Vss/Gnd is applied to the bridge 18. For sensing an external magnetic field *H*_{E} 14 with high sensitivity, usually four magnetic field sensing resistors 20 R1, R2, R3 and R4 comprising one or multiple sensing elements 10 are arranged in such a Wheatstone bridge circuit 18, wherein an asymmetry in the resistance values of the two legs of the Wheatstone bridge leads to a voltage difference *U*ₐ of the bridge. Due to temperature drift, production tolerances and other influences, a remaining offset voltage *U*_{off} cannot be completely made to zero, even when no sensing field *H*_{E} 14 is present. For sensing a vectorial magnetic field in all three dimensions, three magnetic field sensing devices have to be combined.

In order to eliminate an undesired offset voltage *U*_{off}, a flip concept for alternatively flipping the internal magnetization was developed which suggests to flip periodically the internal magnetization *M*₀ 12 of the magnetic field sensing elements 10 by a strong external magnetic flipping field *H*_{flip}, such that a differential value Δ*U*ₐ of two flipped states of the Wheatstone bridge 18 can be used for determining the magnitude of the external field H_{E} 14. The internal magnetizations *M*₀ 12 of the single magnetic field sensing elements 10 of the bridge resistors 20 R1, R2, R3 and R4 are periodically flipped by an external magnetic flipping field *H*_{flip}. A typical strength of a magnetic flipping field is 0.1 to 50mT. After each flipping step the output value Δ*U*ₐ of the Wheatstone bridge 18 changes symmetrically around *U*_{off} in dependence of the two flipped magnetization states *H*_{flip} according to the *R*/Θ relation curve, as depicted in **Fig. 3b****.** The sensor signal *U*ₐ is an alternating sensor signal, wherein a sensing circuit eliminates the static offset value *U*_{off} and determines the strength of *H*_{E} in dependence of Δ*U*ₐ.

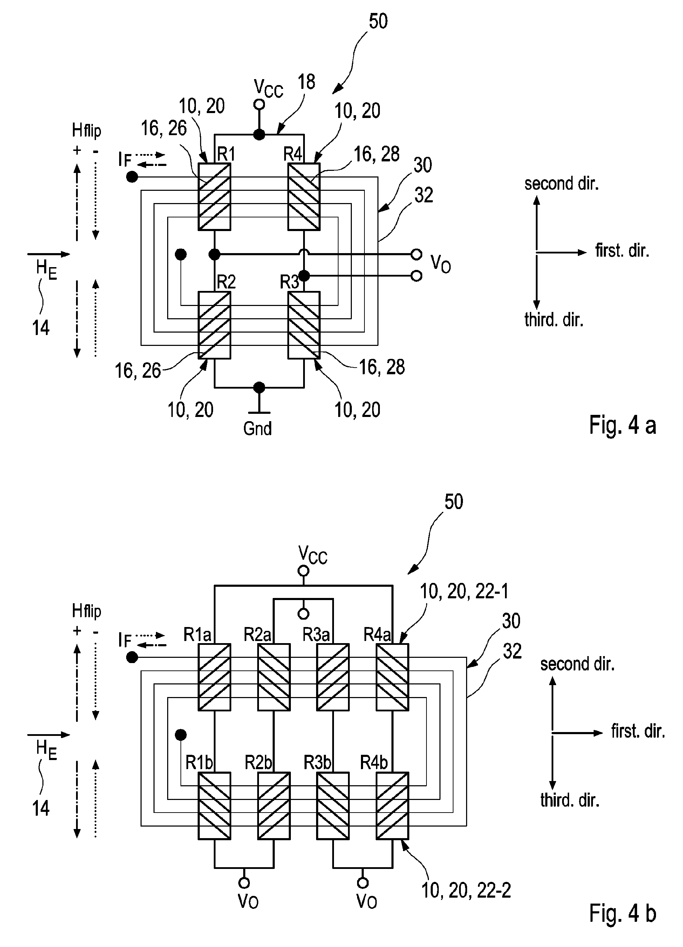

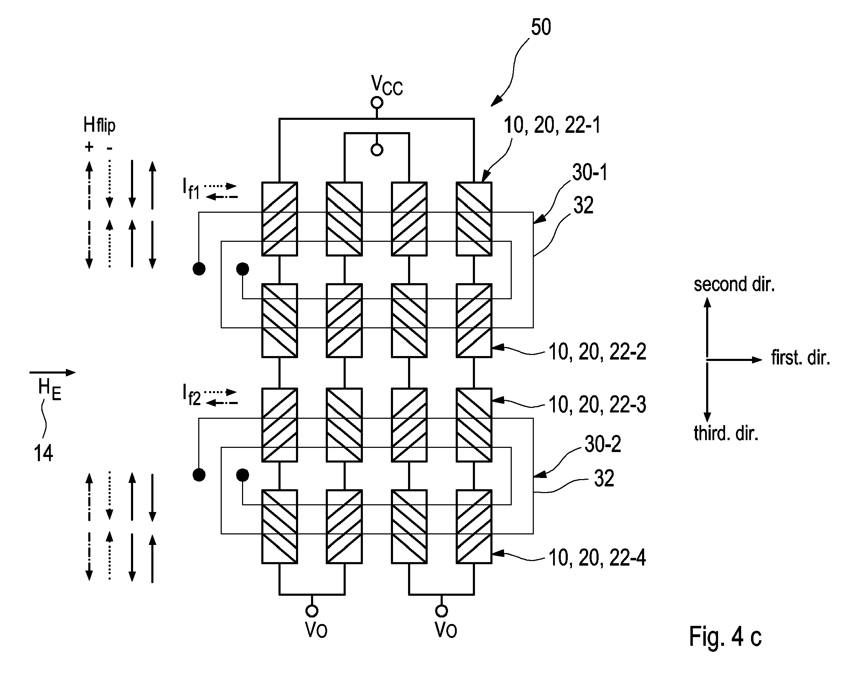

In the last years, different AMR sensor designs based on said Barberpole and flipping concept were the object of discussion. **Fig. 4** shows different basic concepts of magnetic field sensing devices 50 with flip conductor 30 in an illustrative and abstract representation, wherein Wheatstone bridge resistors 20 comprise single or multiple magnetic field sensing elements 10 as subresistors 22, 22-1 to 22-4, and a single 30 or two electrically separate flip conductors 30-1, 30-2.

**Fig. 4a** displays a magnetic field sensing device 50 with an integrated flip coil 30, whereby each magnetic field sensing element 10 forming a resistor R1, R2, R3 and R4 20 with alternating Barberpole structures 16, 26, 28. The magnetic field sensing elements R1, R4 10 of the upper part of the Wheatstone bridge 16 are exposed to a magnetic flipping field *H*_{flip} of an opposing direction in contrast to the magnetic field sensing elements 10 R2, R3 of the lower part of the Wheatstone bridge 18, such that R1, R4 10 are magnetized in one direction and R2, R3 10 in the opposing direction (see dashed-dotted and dotted arrows of the *H*_{flip} direction). The magnetic flipping field *H*_{flip} is generated by a flipping current *I*_{F}, which can be a current pulse flowing through a flip conductor 30, comprising multiple conductor stripes 32 being formed as a spiral. Conductor stripes 32 perpendicularly oriented with respect to the magnetic field sensing elements 10 generate said magnetic flipping field *H*_{flip} according to Ampere's Law and conductor stripes 32 oriented in parallel to the length orientation of the magnetic field sensing elements 10 provide an electrical connection of the magnetically active conductor stripes 32. In consequence, a flipping of the *R*/Θ relation curve is achieved such that an offset voltage *U*_{off} can be eliminated and a compact sensor configuration with integrated flip coils having a small size is provided.

In 1993, the Institute for Microstructure Technology and Optoelectronics (IMO), Wetzlar, Germany proposed a sensing device 50 depicted in **Fig. 4b****,** wherein each bridge resistor R1, R2, R3, R4 20 is split into at least two resistor subparts a and b, each one comprising a magnetic field sensing element 10 as subpart 22-1 or 22-2, having alternating Barberpole structures 16, 26, 28. Each subresistor 22-1, 22-2 (R1 a, R1 b...) is exposed to an opposing part of the magnetic flipping field *H*_{flip} of the flip conductor 30 gemerated by a flip current *I*_{F} to further decrease the sensor offset caused by production tolerances or temperature variations of the sensing elements 10 and to achieve an even more compact arrangement of the resistors 20, thus leading to a smaller chip size.

**Fig. 4c** schematically shows a further development of the magnetic field sensing element device 50 of **Fig. 4b****,** wherein the flip conductor 30 is split into two independent flip conductor parts 30-1 and 30-2. Each resistor 20 is divided into four subresistors 22-1 to 22-4. The two conductor parts 30-1, 30-2 individually and independently allow to adjust the magnetic flipping field *H*_{flipp} for each subresistor 22-1, 22-2, 22-3 and 22-4. Half of the subresistors 22 of each resistor 20 cover one of the two electrically separate flip conductors 30-1, 30-2. Depending on the correlation of both flipping currents *I*_{F1}, *I*_{F2} a "normal" flipping mode (parallel currents)and a "deactivation" mode (opposing currents) can be set, thus enabling a self-calibration of the sensing device 50: The two flip conductors 30-1, 30-2 can provide four different flipping states (see +/-/0/0 *H*_{flip} states), whereby in case of opposing flipping currents *I*_{F} (*H*_{flip} 0/0), the sensitivity of the Wheatstone bridge is nearly eliminated (deactivated) and the output signal represents the offset voltage *U*_{OFF}.

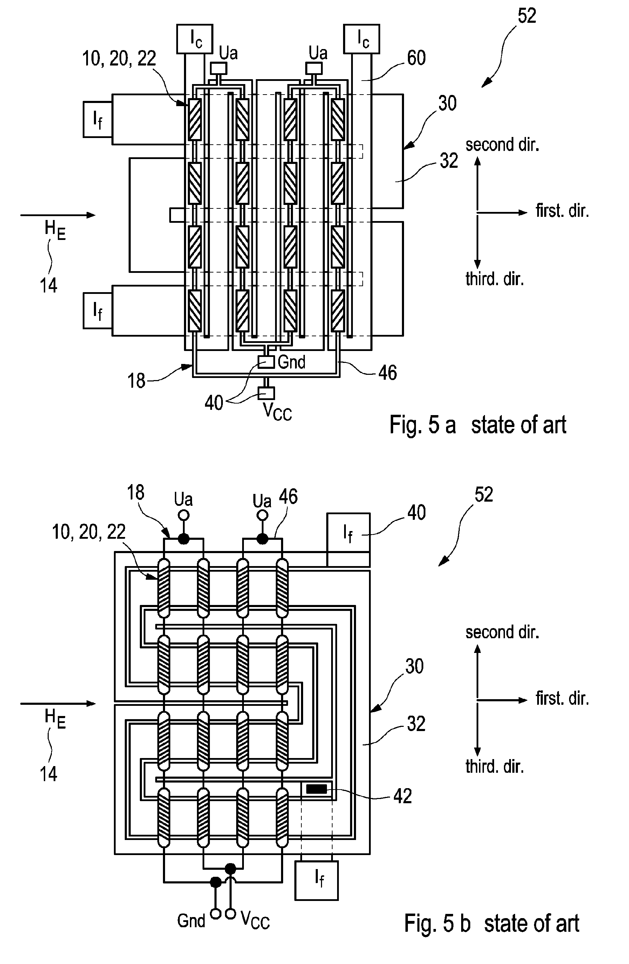

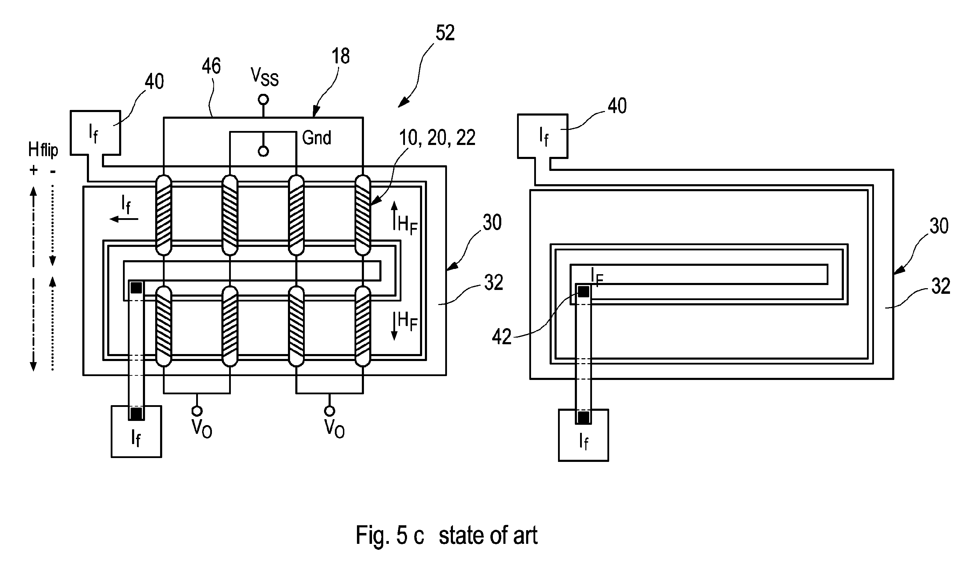

**Fig. 5** shows different magnetic field sensing devices 50 as sensor chip layouts with flip conductor arrangements of a state of the art. **Fig. 5a** shows a first state-of-the-art magnetic field sensing device 52, which comprises a Wheatstone bridge 18, wherein each bridge resistor 20 comprises four magnetic field sensing elements 10 in the form of resistor subresistors 22. The resistors 20 are series- connected and arranged in a meandering form, whereby at each connection point between two resistors 20, contacting pads 40 (Ua, Vcc, Gnd) allow to contact the Wheatstone bride configuration 18 as explained in Fig. 3. At the lower part of the Wheatstone bride 18, supply pads 40 for ground Gnd and supply voltage V_{CC} are arranged. The upper contacting pads 40 allow access to the sensor voltage Ua of the Wheatstone bride to measure a voltage difference Δ*U*ₐ. The Wheatstone bride 18 is arranged on top of a single flip conductor layer, wherein a meandering-shaped flip conductor 30 is arranged such that the flipping current *I_{F},* which can be coupled through contacting pads 40, can flow through the contacting stripes 32 of the flip conductor 30 for generating a magnetic flipping field *H*_{flip} in a second or third direction. The flip conductor 30 is arranged on a single layer, determines the dimension of the overall chip structure and provides the space, in which the Wheatstone bride 18 is arranged. On an electrically insulated additional layer, a compensation conductor 60 is arranged, which is also designed in a meandering form with twice the number of meandering slopes as the number of bridge resistors 20 of the Wheatstone bridge 18, and which provide an electrical compensation field for compensating an external magnetic field. The compensation conductor 60 is based on the same principle as the flip conductor 30, but generates a magnetic field provided by a compensation current *I_{C}* which is not aligned longitudinally to the magnetic field sensing elements 10, but perpendicularly, thus not affecting the internal magnetization *M*₀ but superimposing or compensating an external magnetic field *H*_{E} 14 to be measured.

**Fig. 5b** shows a similar state-of-the-art magnetic field sensing device 52, which also comprises a Wheatstone bridge 18, wherein each bridge resistor 20 consists of four magnetic field sensing elements 10 in the form of subresistors 22. This sensing device 50 comprises a magnetic field flip conductor 30 being located on a separate single layer of the chip 50, wherein the conductor stripes 32 are arranged in a rather complicated interlaced meandering form. The electric conductors 32 of the flip conductor 30 are provided with contacting pads 40, through which a flipping current pulse *I*_{F} can be coupled and extracted. The lower contacting pad 40 is coupled with the conductor stripes of the flip conductor 30 by use of a via connection 42 on a different layer, which is an electric conducting through hole between two layers and a short conductor stripe for contacting the pad 40 with the first conductor stripe 32 of the flip conductor 30.

A further modification of the magnetic field sensing device 52 of **Fig. 5b** is depicted in **Fig. 5c****.** The Wheatstone bridge 18 comprises four resistors 20, wherein each resistor 20 consists of two magnetic field sensing elements 10 as subresistors 22. The four bridge resistors 20 are electrically connected in series and are arranged in a meandering form over a spirally-wound magnetic flip conductor 30. Both magnetic field sensing elements 10, i.e. subresistors 22 of each resistor 20 are located on top of horizontally aligned conducting stripes 32 of a flip conductor 30. A first magnetic field sensing element 10 (subresistor 22) of each resistor 20 is arranged on top of a magnetically active conductor stripe 32 (horizontally oriented stripe 32) of the flip conductor 30 generating an upwardly directed flipping field *H*_{flip}, and a second element 10 is arranged on top of a magnetically active conductor stripe 32 generating a downwardly directed *H*_{flip} fields.The flip conductor 30 is connected to contacting pads 40 and has a spiral shape. The *H*_{flip} flipping field is generated by a flipping current *I*_{F} flowing through the flip conductor 30. The ending conductor stripe 32 at the center of the spiral is connected to the contacting pad 40 by vias 42 and a conductor stripe, which is located on an subsequent layer. On the right-hand side of **Fig. 5c****,** the flip conductor configuration 30 as well as the connecting conductor and the vias 42 are displayed.

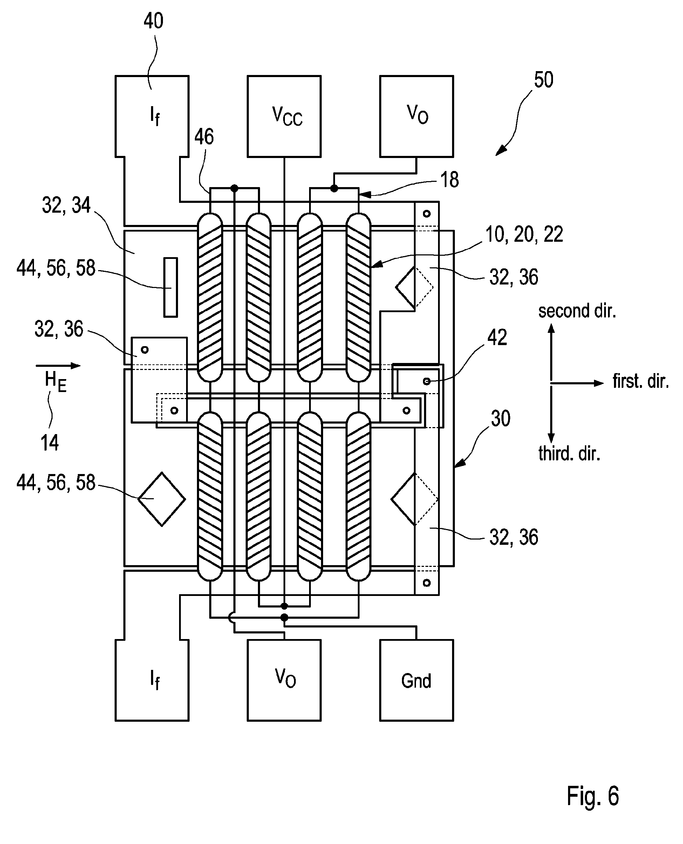

**Fig. 6** shows a first embodiment of a magnetic field sensing device 50 according to the invention. The magnetic field sensor chip 50 comprises a Wheatstone bridge 18, wherein each bride resistor 20 comprises two subresistors 22, which are designed as magnetic field sensing elements 10 with alternating Barberpole structures 16, 26, 28. The Wheatstone bridge 18 is arranged on a first layer of the device 50. The Wheatstone bridge 18 is connected to four contacting pads 40 for supplying the Wheatstone bridge 18 with electric energy Vcc, Gnd and for sensing a voltage difference ΔVₒ from pads Vo as a result of an external magnetic field *H*_{E} 14. The Wheatstone bridge 18 is arranged on top of a flip conductor layer 38, which comprises two sublayers 38-1 and 38-2.

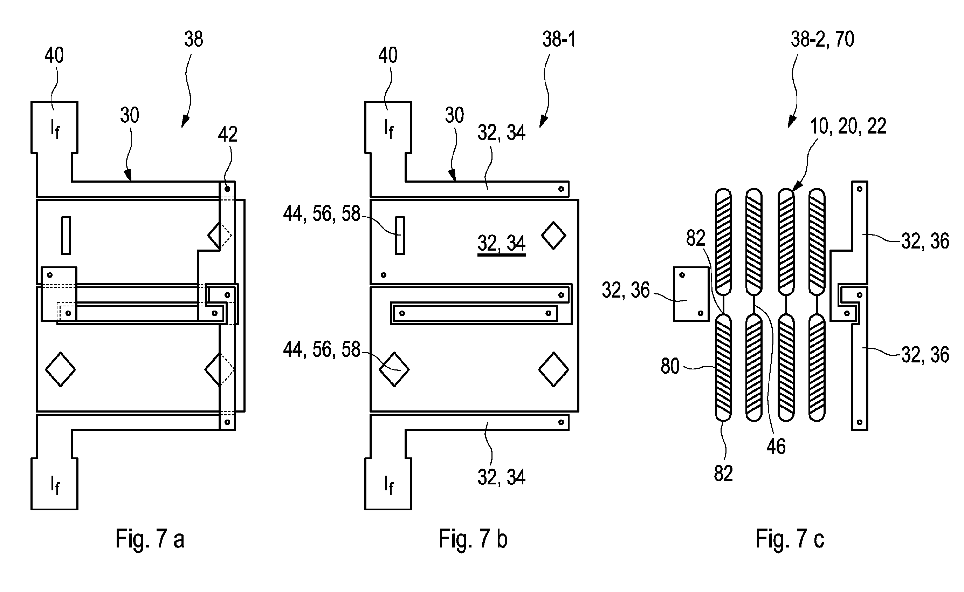

A detailed drawing of the individual sublayers is depicted in **Fig. 7a** to **Fig. 7c****.** A flip conductor 30 is arranged on a flip conductor layer 30 and can be contacted by contacting pads 40, for feeding a flipping current pulse *I*_{F} into the conductor coil thus generating a magnetic flipping field *H*_{flip}. The overall design of the flip conductor 30 is double spiral-shaped, wherein the horizontally oriented conductor stripes 32, which generate a flipping field *H*_{flip}. in the alignment direction of the magnetic field sensing elements 10, are arranged on a first sublayer 38-1, displayed in **Fig. 7b****.** The horizontally oriented magnetically active conductor stripes 32 of sublayer 38-1 form a first set 34 of conductor stripes for generating the flipping field *H*_{flip}. The conductor stripes 32 of the first set 34 are connected to vertically oriented connecting conductor stripes 32 forming a second set of conductor stripes 36 for electrical connection of the stripes 32 of the first set 34 and being arranged on a second sublayer 38-2, shown in **Fig. 7c****.** Both sets of conductor stripes 34, 36 are electrically connected through vias 42 between the sublayers 38-1, 38-2. Thus, the flipping current *I*_{F} can flow through segmented conductor stripes 32 of the first and second sublayer 38-1, 38-2. The first set of conductor stripes 34 comprises conductor stripes 32 being arranged at the end parts 82 of the magnetic field sensing elements 10, which have a smaller width compared to the conductor stripes 34, which are arranged in the center part 80 of the magnetic field sensing elements 10. In this way, an increased magnetic flipping *H*_{flip} field can be generated at the end parts 82 of the magnetic field sensing elements 10 with respect to the center parts 80 of the sensing elements 10. Thus, the flipping current *I*_{F} can be lowered and the inductance of the magnetic flip conductor 30 can be decreased for achieving a solid flipping of the internal magnetization *M*₀ of the sensing elements 10, and due to a reduced magnetic stray field and thus lower inductance higher flip frequencies allow an increase of temporal resolution, since a higher number of measurements can be obtained during a fixed time interval. Conductor stripes 32 of the first set of conductor stripes 34 associated to the center part 80 of the magnetic field sensing elements 10 comprises current distribution elements 44 in the form of non-conducting areas 56, which are designed to distribute the flipping current *I*_{F} homogeneously over the conductor stripe 32. The current distribution elements 44 provide a homogeneous current distribution, such that a decreased homogeneous magnetic flipping field *H*_{flip} is generated in the center part 80 of the magnetic field sensing elements10 and an increased magnetic flipping field *H*_{flip} is generated at the end parts 82 of the magnetic field sensing elements 10. The current distribution elements 44 help to decrease the magnitude of the magnetic flipping current *I*_{F} and form the current distribution profile in a way so as to optimize the flipping mechanism and to reduce electric energy consumption.

**Fig. 7a** schematically depicts the layout of the flip conductor 30, which is arranged on a flip conductor layer 38. The flip conductor 30 is electrically contactable via contacting pads 40, wherein the electric flipping current *I*_{F} can enter into and can be extracted from the flip conductor 30. The first set of conductor stripes 32, displayed in **Fig. 7b****,** which generates the magnetic flipping field, is arranged on a first sublayer 38-1 and is connected to a second set of conductor stripes 32 arranged on a second sublayer 38-2, shown in **Fig. 7c****.** Current distribution elements 44 in the form of rectangular and polygonal recesses 58 are arranged on the relatively wide conductor stripes being associated to the center part 80 of the magnetic field sensing elements 10. The electric connection between conductor stripes 32 of the first and second sublayer is provided by vias 40. The second sublayer 38-2 can be arranged on top of the first sublayer 38-1 and can also comprise the bridge resistors 20 of the Wheatstone bridge 18 with its subresistors 22 consisting of magnetic field sensing elements 10. Consequently, the whole sensor chip configuration 50 comprises two sublayers 38-1 as bottom layer and 38-2 as top layer, wherein the second sublayer 38-2 also comprises the Wheatstone bridge layer 70. This arrangement provides a very compact chip design with increased magnetic sensitivity and lower energy consumption.

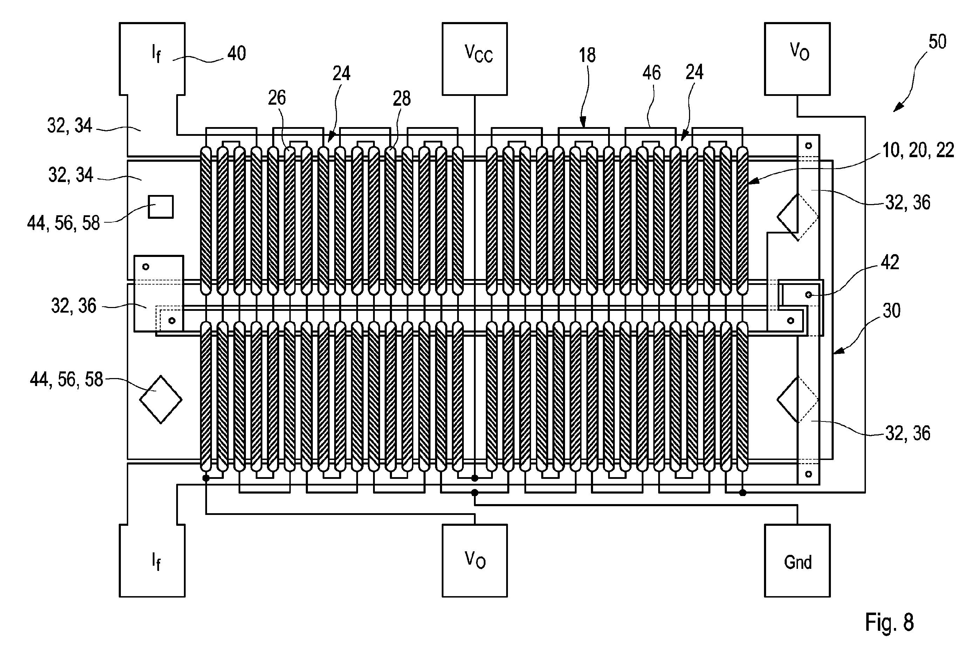

**Fig. 8** displays a second embodiment of a magnetic field sensing device 50 with an interdigital arrangement 24 of bridge resistors 20. The flip conductor arrangement 30 is similar to the flip conductor of the embodiment depicted in **Figs. 6****,** **7****.** The Wheatstone bridge 18 comprises four resistors 20, whereby each resistor 20 comprises a plurality of magnetic field sensing elements 10 in the form of subresistors 22. The magnetic field sensing elements 10 of each resistor 20 are series-connected, whereby two sensing elements 10 with alternating Barberpole structures 26, 28 are arranged on magnetically active conductor stripes 32 of the first sublayer 38-1 of the flip conductor 30 generating opposing magnetic flipping fields *H*_{flip}. The series-connected elements 10 of each resistor 20 are arranged in a meandering form, such that interdigitating fingers are formed. The fingers of two resistors 20 interact such that the bridge resistors 20 are formed in an interdigital arrangement 24, wherein magnetic elements 10 of neighboring resistors are arranged close to another. Due to the compact arrangement of the sensing elements 10 of the bridge resistor 20 material impurities, defects or temperature variations affect both resistors in an equal manner, thus enhancing stability and accuracy of the sensing device.

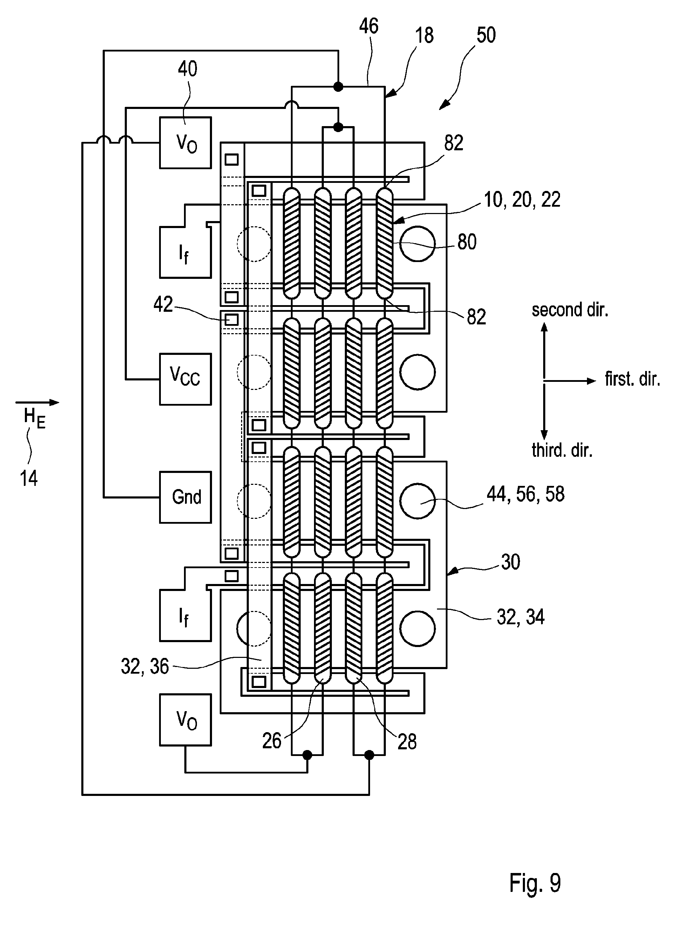

**Fig. 9** shows another embodiment of a magnetic field sensing device 50, wherein the flip conductor 30 is double meandered and comprises U-shaped conductor stripes 32. In this chip arrangement 50, contacting pads 40 are arranged on a contacting side of the chip layout and individual sensing elements 10 of the bridge resistors 18 are arranged in a series connection along the double meandered flip conductor 30. Each resistor 20 comprises four magnetic field sensing elements 10 with alternating Barberpole structures 26, 28, which are located on top of a set 34 of magnetically active conductor stripes 32 of the flip conductor 30 generating opposing magnetic flipping fields.

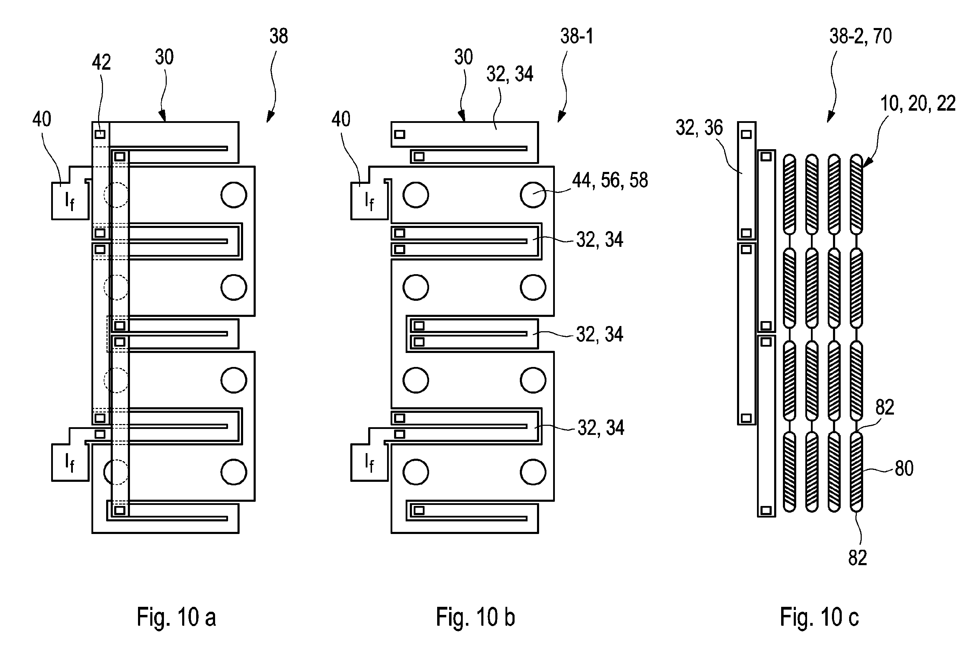

Details of the flip conductor arrangement 50 of **Fig. 9** are depicted in **Fig. 10. Fig. 10a** reveals the structure of the flip conductor 30 located on two sublayers 38-1 shown in **Fig. 10b** and 38-2, shown in **Fig. 10c****.** Horizontally oriented first set conductor stripes 32, 34 on flip conductor layer 38-1 are arranged in a meandering form and comprise U-shaped conductor stripes associated to the end parts 82 of the magnetic field sensing elements 10. For providing a homogeneous current density of the conductor stripes 32 associated to the center part 80 of the magnetic field sensing elements 10, nonconductive recesses 58 are provided, which have a circular or elliptic shape. The current distribution elements 44 homogenize the current density of the flipping current *I*_{F}, thus providing a homogenous magnetic flipping field *H*_{flip} for the center part 80 of the magnetic field sensing elements 10. The AMR sensing elements 10 of a Wheatstone bridge layer 70 are arranged on a second sublayer 38-2 together with vertically oriented conductor stripes 36 of the second flip conductor set 32, 36. The two sets of conductor stripes 34, 36 are electrically connected by vias 42.

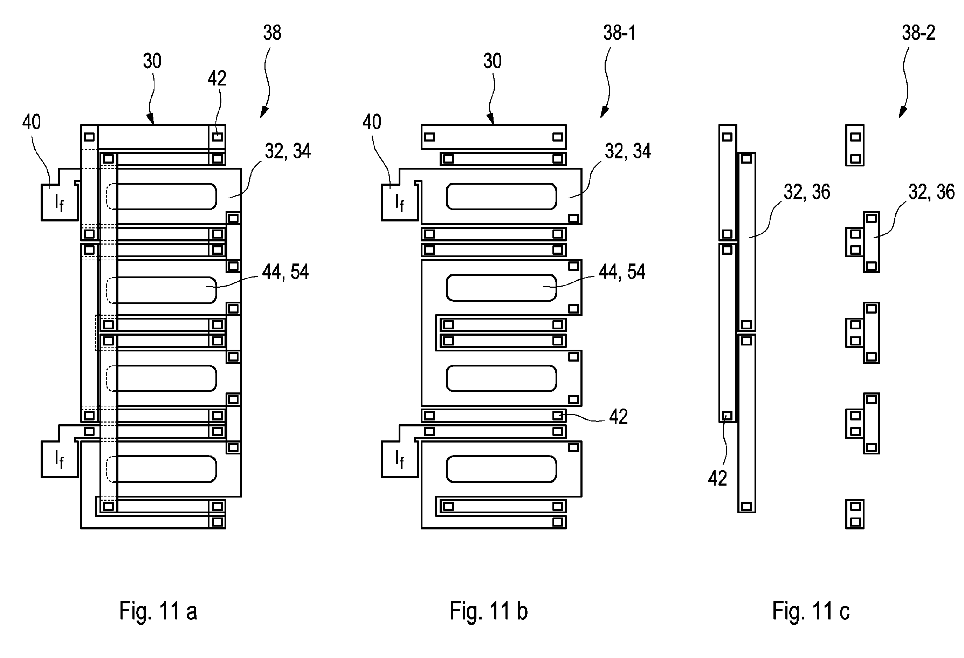

**Fig. 11** depicts an alternative configuration of a flip conductor 30 of the chip configuration displayed in **Fig. 9****.** Fig 10a displays the overall shape of flip conductor 30 of the flip conductor layer 38. The first sublayer 38-1 of **Fig. 11b** comprises only horizontally oriented magnetically active conductor stripes 32, 34, while the second sublayer 38-2 depicted in **Fig. 11c** only comprises vertically oriented conductor stripes 32, 36. Magnetic field sensing elements 10 (not shown) can favorably be arranged on the same layer of Fig. 11c as the second set of flip conductor stripes 36. The conductor stripes of both sublayers 38-1 and 38-2 are connected by vias. Sublayer 38-2 is arranged over sublayer 38-1 and can also comprise sensing elements 10 of a Wheatstone-bridge layer 70, not shown. The magnetically active conductor stripes 32 of the first set of conductor stripes 34 being associated to the center part 80 of the magnetic field sensing elements 10 comprise a conductance profile 54 for generating a homogenous decreased magnetic flipping field in comparison to the conductor stripes 32 associated to the end part 82 of the magnetic field sensing elements 10. In comparison to the flip conductor design of **Fig. 9****,** the number of via connections 42 is increased, but the overall size of the chip area is further reduced due to the strict separation of vertically and horizontally oriented conductor stripes 34, 36.

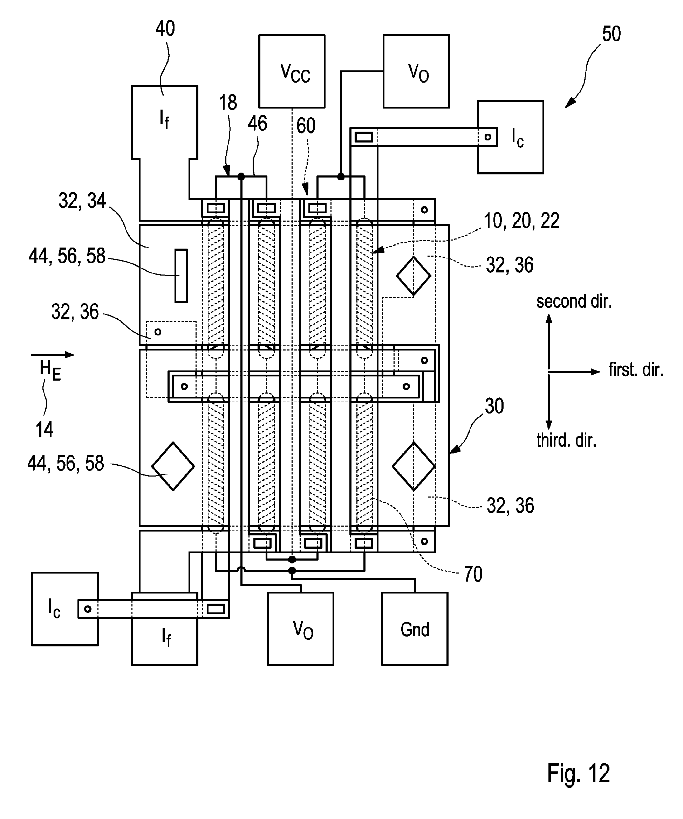

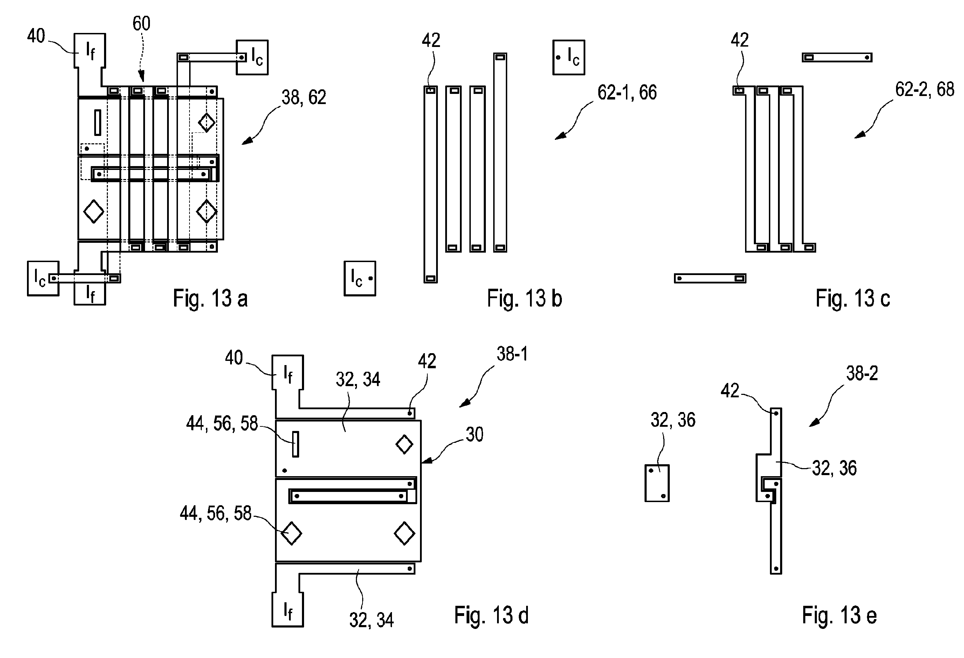

**Fig. 12** displays another embodiment of a magnetic field sensing device 50 with a flip conductor 30 and a compensation conductor 60 being arranged on stacked layers 38, 6β on top of and underneath a Wheatstone bridge layer 70. The flip conductor arrangement is similar to the flip conductor of the embodiment depicted in **Fig. 6****.** The sensing device 50 is adapted to sense a magnetic field component *H*_{E} in a first direction and comprises magnetic field sensing elements 10 which can be magnetized in a second or third direction depending on the direction of the magnetic flip field *H*_{flip}. The layer arrangement of flip conductor 30 and compensation conductor 60 of sensing device 50 is shown in Fig. 13.

**Fig. 13a** displays a configuration of conductor stripes 32 of the chip design of Fig. 12 comprising a flip conductor sublayer 38-1 shown in **Fig. 13d** and 38-2 displayed in **Fig. 13e** of flip conductor 30 and sublayers 62-1 depicted in **Fig. 13b** and 62-2 in **Fig. 13c** of a compensation conductor 60. The compensation conductor 60 as well as the flip conductor 30 comprise two sublayes 38-1, 38-2, 62-1 and 62-2 respectively, wherein the first sets of magnetically active conductor stripes 34, 66 respectively are arranged on a first sublayer 38-1, 62-1 and the second sets of conductor stripes 36, 68 respectively for electrically conducting the first set of conductor stripes 34, 66 are arranged on a second sublayer 38-2, 62-2. The sublayers 38-1, 38-2 and 62-1, 62-2 can be stacked on top of one another or can sandwich the Wheatstone bridge layer 70. Contacting pads 40 surround the layer stack assembly for conducting Wheatstone bridge 18 as well as flip conductor 30 and compensation conductor 60. The compensation conductor 60 is designed for generating an electric compensation field to compensate an external magnetic field *H*_{E} 14, wherein the magnetic compensation field is oriented perpendicular to the length arrangement of magnetic field sensing elements 10 (not shown). Said magnetic field sensing elements 10 (not shown) can favorably be arranged on the layer depicted in Fig. 13e in parallel to the second set of flip conductor stripes 36 of flip conductor sublayer 38-2. Since the sublayer concept of the flip conductor 30 can also be applied to the compensation conductor 60, it is also conceivable and favorable to arrange the flip conductor 30 on a single layer and to arrange the two sets of conductor stripes 66, 68 of the compensation conductor 60 on two sublayers 62-1, 62-2, thereby transferring the advantages of the invention to the compensation conductor layer arrangement 60.

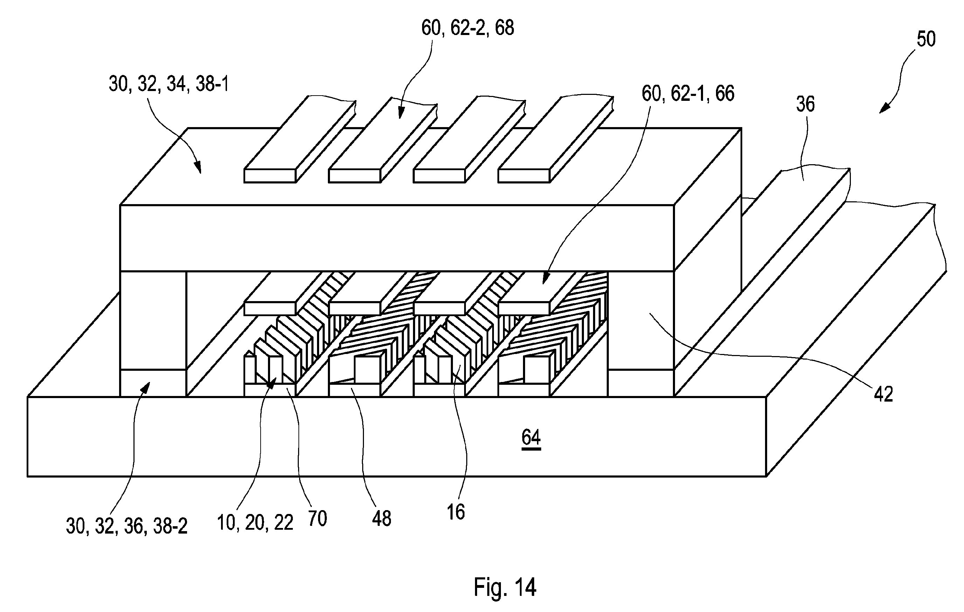

Finally, **Fig. 14** displays an schematic and exploded sectional view of a three-dimensional magnetic sensor chip arrangement 50 as depicted in **Fig. 12****,** comprising flip conductor layer 30, compensation conductor layer 60 and Wheatstone bridge layer 70 on a substrate 64, depicted in Fig. 13. The three-dimensional representation of the chip-layout is purely illustrative and does not represent any real dimension. On the substrate 64, magnetic field sensing elements 10 of four bridge resistors 20 are arranged on a Wheatstone-bridge layer 70, comprising an AMR material stripe 48, e.g. a permalloy stripe and a barberpole structure 16 made of highly conductable material, such as gold or copper. Four resistors 20 of a Wheatstone bridge 18 cover the main substrate area of the magnetic field sensing device 50. Each resistor 20 comprises a plurality of subresistors 22, whereby each subresistor 22 is a magnetic field sensing element 10. Each magnetic field sensing element 10 comprises an AMR-material stripe 48, e.g. a permalloy stripe and a barberpole structure 16 of highly conducting material on top. On the same Wheatstone-bridge layer 70 on which the magnetic field sensing elements 10 are arranged, a second flip conductor sublayer 30, 38-2 is provided comprising a second set of flip conductor stripes 32, 36 for electrically connecting conductor stripes 34 of a first set of flip conductor stripes 34 - see similar configurations displayed in **Figs. 7c****,** **10c****,** **11c** or **Fig 13e****.** The metallization of second set of flip conductor stripes 36 and of barberpole structures 16 can be identical and can be fabricated in parallel. On top of said combined layer 70, 38-2 , a first compensation conductor sublayer 62-1 comprising a first set of compensation conductor stripes 66 is arranged such that a magnetic compensation field can be generated to compensate an external magnetic field *H*_{E} - see also configuration of **Fig. 13b****.** On top of the first compensation conductor sublayer 62-1, a first flip conductor sublayer 38-1 is arranged comprising a set of magnetically active flip conductor stripes 34 - see also **Fig. 13d****.** The first set 34 of the flip conductor 30 is connected to the second set 36 of the magnetic flip layer 38 through via conductor elements 42, which can favorably processed in parallel to conducting stripes 32 of the first set of compensation conductor stripes 66. Finally, on top of the first flip conductor sublayer 38-1, a second compensation conductor sublayer 62-2 is arranged comprising a second set of conductor stripes 68 for connecting the first set of magnetically active conductor stripes 66 of the first compensation conductor sublayer 60-1 - see **Fig. 13c****.** The conductor stripes 32 of the first and second set of compensation conductor stripes 66, 68 are connected by vias which are not shown. A staggered design of sublayers 38-1, 38-2, 62-1, 62-2 provides a highly integrated and compact chip design with a minimal stray field and low inductance which can be operated with low power consumption at high frequency and increased sensitivity.

Due to the shape of its magnetic field sensing elements 10 and its flip conductor 30, the resistance of the flip coil 30 can be decreased down to 1Ω per sensor chip 50, such that the *H*_{flip} field can be generated by an 200 mA current *I*_{F} at a voltage *V*_{F} of less than 1.5 V. The special design of the flip conductor 30 generates an increased *H*_{flip} field at both ends 82 of the elements 10 and a smaller *H*_{flip} field in the center part 80 of the elements 10, such that the internal magnetization *M* can be flipped by an overall decreased *H*_{flip} field strength. Furthermore, the reduced diameter of the end parts 82 of each element 10 allows to apply a decreased *H*_{flip} field for solidly flipping the internal magnetization *M₀.* The improved design provides a small and compact sensor chip arrangement 50 which can be enlarged to a 3D sensor chip and which can be driven by a comparatively low voltage which can be delivered by a 1.2 V rechargeable battery of a portable device. The present invention is not limited to the above examples, but may be varied freely within the scope of the appended claims.

### Reference Numerals

- 10: Magnetic field sensing element
- 12: Internal magnetization M
- 14: External magnetic field
- 16: Barberpole structure
- 18: Wheatstone bridge
- 20: Bridge resistor
- 22: Bridge subresistor
- 24: Interdigital resistor subelement arrangement
- 26: Barperpole structure with positive angle
- 28: Barperpole structure with negative angle
- 30: Flip conductor
- 32: Conductor stripe
- 34: First set of conductor stripes for flipping field
- 36: Second set of conductor stripes for electrical connection
- 38: Flip conductor layer
- 40: Contacting pad
- 42: Via
- 44: Current distribution element
- 46: Electric connection between magnetic field sensing elements
- 48: AMR material stripe
- 50: Magnetic field sensing device
- 52: State-of-the-art magnetic field sensing device
- 53: Current density distribution
- 54: Conductance profile
- 56: Non-conducting area
- 58: Recess
- 60: Compensation conductor
- 62: Compensation conductor layer
- 64: Substrate
- 66: First set of compensation conductor stripes for compensation field
- 68: Second set of compensation conductor stripes for electrical connection
- 70: Wheatstone bridge layer
- 72:
- 74:
- 76:
- 78:
- 80: Center part of magnetic field sensing element
- 82: End part of magnetic field sensing element

## Claims

1. A magnetic field sensing device (50) comprising several functionally different layers (38, 60, 70), wherein a Wheatstone bridge layer (70) comprises at least two resistors (20) of a Wheatstone bridge (18), each resistor (20) comprises at least one magnetic field sensing element (10) in the form of a subresistor (22), and a flip conductor layer (38) comprises at least one flip conductor (30) for flipping the internal magnetization state of each magnetic field sensing element (10), **characterized by** said flip conductor (30) comprising a plurality of conductor stripes (32) being arranged on at least two different flip conductor sublayers (38-1, 38-2) of said flip conductor layer (38) and being electrically coupled with each other through vias.

2. The magnetic field sensing device according to claim 1, **characterized by** an arrangement of a first set of conductor stripes (32, 34) for providing a magnetic flipping field of an associated magnetic field sensing element (10) and being arranged on a first flip conductor sublayer (38-1) facing a Wheatstone bridge layer side (70), and at least a second set of conductor stripes (32, 36) for providing an electrical connection of said first set of conductor stripes (34) and being arranged on at least one second flip conductor sublayer (38-2).

3. The magnetic field sensing device according to claim 2, **characterized by** said first set of conductor stripes (32, 34) being essentially perpendicularly oriented with respect to a longitudinal alignment of said magnetic field sensing element (10), and said second set of conductor stripes (32, 36) being essentially oriented in parallel with respect to said longitudinal alignment of said magnetic field sensing element (10).

4. The magnetic field sensing device according to claim 2 or 3, **characterized by** said first set of conductor stripes (32, 34) comprising an interdigital arrangement of said perpendicularly oriented conductor stripes (34) for providing a magnetic flipping field for a center part (80) of said magnetic field sensing element (10), and perpendicular conductor strips (34) for providing a magnetic flipping field for end parts (82) of said magnetic field sensing element (10).

5. The magnetic field sensing device according to any of the aforementioned claims, **characterized by** said first set of conductor stripes (34) being designed and arranged so that an increased magnetic flipping field can be provided at both end parts (82) of each magnetic field sensing element (10) with respect to a magnetic flipping field provided for a center part (80) of said magnetic field sensing element (10).

6. The magnetic field sensing device according to any of the aforementioned claims 2 to 5, **characterized by** at least one conductor stripe of said first set of conductor stripes (32, 34) comprising at least one current distribution element (44) being designed to provide a current distribution, such that a homogeneous magnetic flipping field can be excited in a center part (80) of a magnetic sensing element (10), preferably a conductance profile (54) or a non-conducting area (56) of the conductor stripe (32, 34), especially a recess (58), whereby preferably said conductor stripe (32, 34) is adapted for flipping the internal magnetization state of the center part (80) of said magnetic field sensing element (10).

7. The magnetic field sensing device according to any of the aforementioned claims, **characterized by** said resistor (20) comprising at least two magnetic field sensing elements (10) in the form of subresistors (22), whereby each magnetic field sensing element (10) comprises a Barberpole structure (16) with a positive or a negative Barberpole alignment (26, 28) depending on its arrangement with respect to a current flow direction of the associated perpendicular conductor stripe (34) of the flip conductor (30).

8. The magnetic field sensing device according to claim 7, **characterized by** an interdigital arrangement (24) of subresistors (22) of said at least two resistors (20) on said Wheatstone bridge layer (70).

9. The magnetic field sensing device according to any of the aforementioned claims, **characterized by** a tapered form, preferably an elliptic form of both longitudinal end parts (82) of said magnetic field sensing element (10).

10. The magnetic field sensing device according to any of the aforementioned claims, **characterized by** said bridge resistors (20) being arranged on a Wheatstone bridge layer (70) beneath said first flip conductor sublayer (38-1) and/or within said second flip conductor sublayer (38-2).

11. The magnetic field sensing device according to any of the aforementioned claims, **characterized by** a compensation conductor (60) for generating a magnetic compensation field to compensate an external magnetic field, whereby said compensation conductor (60) is disposed on at least one compensation conductor layer (62), preferably on top of said Wheatstone bridge layer (70) and adjacent to and/or staggered with said flip conductor layer (38).

12. The magnetic field sensing device according to claim 11, **characterized by** said compensation conductor (60) comprising multiple conductor stripes (32) being arranged on at least two different compensation conductor sublayers (62-1, 62-2) of said compensation conductor layer (62) and being electrically coupled through vias with each other, such that a first set of compensation conductor stripes (66) for providing a magnetic compensation field is arranged on said first compensation conductor sublayer (62-1), and a second set of compensation conductor stripes (68) for providing an electrical connection of said first set of compensation conductor stripes (66) is arranged on said second compensation conductor sublayer (62-2), and wherein said first set of compensation conductor stripes (66) is arranged above and adjacent to said Wheatstone bridge layer (70) and beneath said first flip conductor sublayer (38-1).

13. The magnetic field sensing device according to any of the aforementioned claims, **characterized by** at least a part of said flip conductor (30) and/or said compensation conductor (60) being arranged essentially in a U-shaped, spiral-shaped and/or a meandering form.

14. The magnetic field sensing device according to any of the aforementioned claims, **characterized by** the material of said flip conductor (30) and/or said compensation conductor (60) is highly conductive, preferably comprising copper, aluminum, silver, gold or an alloy thereof, and is preferably identical to the material forming the Barberpole structure (16).

15. The magnetic field sensing device according to any of the aforementioned claims, **characterized by** two or more electrically separated flip conductors (30-1, 30-2) each provided for independently flipping a magnetization state of at least one magnetic field sensing element (10) of a bridge resistor (20).

## Patentansprüche

1. Magnetfeldsensorvorrichtung (50) umfassend mehrere funktional unterschiedliche Schichten (38, 60, 70), wobei eine Wheatstonebrückenschicht (70) mindestens zwei Widerstände (20) einer Wheatstonebrücke (18) und dabei jeder Widerstand (20) mindestens ein Magnetfeldsensorelement (10) in Form eines Unterwiderstands (22) enthält, und wobei eine Umpolleiterschicht (38) mindestens einen Umpolleiter (30) für das Umpolen des internen magnetischen Zustands jedes Magnetfeldsensorelements (10) enthält, **dadurch gekennzeichnet, dass** der Umpolleiter (30) eine Vielzahl von Leiterstreifen (32) enthält, die auf mindestens zwei verschiedenen Umpolleiter-Unterschichten (38-1, 38-2) der Umpolleiterschicht (38) angeordnet und elektrisch miteinander über Durchkontaktierungen verbunden sind.

2. Magnetfeldsensorvorrichtung nach Anspruch 1, **gekennzeichnet durch** die Anordnung eines ersten Satzes von Leiterstreifen (32, 34) für die Bereitstellung eines magnetischen Umpolfeldes eines zugehörigen Magnetfeldsensorelements (10), der dabei auf einer ersten Umpolleiter-Unterschicht (38-1) gegenüber einer Seite einer Wheatstonebrückenschicht (70) angeordnet ist, und **durch** mindestens einen zweiten Satz von Leiterstreifen (32, 36), der die elektrischen Verbindung des ersten Satzes von Leiterstreifen (34) bereitstellt und auf mindestens einer zweiten Umpolleiter-Unterschicht (38-2) angeordnet ist.

3. Magnetfeldsensorvorrichtung nach Anspruch 2, **dadurch gekennzeichnet, dass** der erste Satz von Leiterstreifen (32, 34) im Wesentlichen senkrecht zu einer Längsausrichtung des Magnetfeldsensorelements (10) orientiert ist, und dass der zweite Satz von Leiterstreifen (32, 36) im Wesentlichen parallel zu der Längsausrichtung des Magnetfeldsensorelements (10) orientiert ist.

4. Magnetfeldsensorvorrichtung nach Anspruch 2 oder 3, **dadurch gekennzeichnet, dass** der erste Satz von Leiterstreifen (32, 34) eine fingerartig ineinandergreifende Anordnung der senkrecht orientierten Leiterstreifen (34) umfasst, um ein magnetisches Umpolfeld für das Mittelstück (80) des Magnetfeldsensorelements (10) bereitzustellen, und senkrechte Leiterstreifen (34), um ein magnetisches Umpolfeld für Endstücke (82) des Magnetfeldsensorelements (10) bereitzustellen.

5. Magnetfeldsensorvorrichtung nach einem der vorangegangenen Ansprüche, **dadurch gekennzeichnet, dass** der erste Satz von Leiterstreifen (34) so ausgebildet und angeordnet ist, dass ein magnetisches Umpolfeld an beiden Endstücken (82) eines jeden Magnetfeldsensorelements (10) aufgebaut werden kann, das gegenüber dem für das Mittelstück (80) des Magnetfeldsensorelements (10) aufgebauten magnetischen Umpolfeld erhöht ist.

6. Magnetfeldsensorvorrichtung nach einem der vorangegangenen Ansprüche 2 bis 5, **dadurch gekennzeichnet, dass** mindestens ein Leiterstreifen des ersten Satzes von Leiterstreifen (32, 34) wenigstens ein Stromverteilungselement (44) enthält, das ausgebildet ist, eine Stromverteilung derart zu bewirken, dass ein homogenes magnetisches Umpolfeld in einem Mittelstück (80) eines Magnetfeldsensorelements (10) erzeugt werden kann, vorzugsweise ein Leitfähigkeitsprofil (54) oder einen nichtleitenden Bereich (56) des Leiterstreifens (32, 34), insbesondere eine Aussparung (58), wobei vorzugsweise der Leiterstreifen (32, 34) angepasst ist, um den internen Magnetisierungszustand des Mittelstücks (80) des Magnetfeldsensorelements (10) umzupolen.

7. Magnetfeldsensorvorrichtung nach einem der vorangegangenen Ansprüche, **dadurch gekennzeichnet, dass** der Widerstand (20) mindestens zwei Magnetfeldsensorelemente (10) in der Form von Unterwiderständen (22) enthält, wobei jedes Magnetfeldsensorelement (10) eine Barberpole-Struktur (16) mit einer positiven oder negativen Barberpole-Ausrichtung (26, 28) umfasst, die von dessen Anordnung in Bezug auf die Stromflussrichtung des zugehörigen senkrechten Leiterstreifens (34) des Umpolleiters (30) abhängt.

8. Magnetfeldsensorvorrichtung nach Anspruch 7, **gekennzeichnet durch** eine fingerartig ineinandergreifende Anordnung (24) von Unterwiderständen (22) der mindestens zwei Widerstände (20) auf der Wheatstonebrückenschicht (70).

9. Magnetfeldsensorvorrichtung nach einem der vorangegangenen Ansprüche, **gekennzeichnet durch** eine sich verjüngende Form, vorzugsweise eine elliptische Form der beiden Längsendstücke (82) des Magnetfeldsensorelements (10).

10. Magnetfeldsensorvorrichtung nach einem der vorangegangenen Ansprüche, **dadurch gekennzeichnet, dass** Brückenwiderstände (20) auf einer Wheatstonebrückenschicht (70) unterhalb der ersten Umpolleiter-Unterschicht (38-1) und/oder innerhalb der zweiten Umpolleiter-Unterschicht (38-2) angeordnet sind.

11. Magnetfeldsensorvorrichtung nach einem der vorangegangenen Ansprüche, **gekennzeichnet durch** einen Ausgleichsleiter (60) zur Erzeugung eines magnetischen Kompensationsfelds für die Kompensation eines externen Magnetfelds, wobei der Ausgleichsleiter (60) auf mindestens einer Ausgleichsleiterschicht (62) angeordnet ist, vorzugsweise auf der Oberseite der Wheatstonebrückenschicht (70) und benachbart zur und/oder versetzt mit der Umpolleiterschicht (38).

12. Magnetfeldsensorvorrichtung nach Anspruch 11, **dadurch gekennzeichnet, dass** der Ausgleichsleiter (60) eine Vielzahl von Leiterstreifen (32) aufweist, die auf mindestens zwei verschiedenen Ausgleichsleiter-Unterschichten (62-1, 62-2) der Ausgleichsleiterschicht (62) angeordnet und über Durchkontaktierungen elektrisch miteinander verbunden sind, so dass ein erster Satz von Ausgleichsleiterstreifen (66) für die Erzeugung eines magnetischen Kompensationsfelds auf der ersten Ausgleichsleiter-Unterschicht (62-1) und ein zweiter Satz von Ausgleichsleiterstreifen (68) für die Bereitstellung einer elektrischen Verbindung des ersten Satzes von Ausgleichsleiterstreifen (66) auf der zweiten Ausgleichsleiter-Unterschicht (62-2) angeordnet ist, und wobei der erste Satz von Ausgleichsleiterstreifen (66) oberhalb und benachbart zu der Wheatstonebrückenschicht (70) und unterhalb der ersten Umpolleiter-Unterschicht (38-1) angeordnet ist.

13. Magnetfeldsensorvorrichtung nach einem der vorangegangenen Ansprüche, **dadurch gekennzeichnet, dass** mindestens ein Teil der Umpolleiter (30) und/oder der Ausgleichsleiter (60) im Wesentlichen in einer U-förmigen, einer spiralförmigen und/oder einer mäanderförmigen Form angeordnet ist.

14. Magnetfeldsensorvorrichtung nach einem der vorangegangenen Ansprüche, **dadurch gekennzeichnet, dass** das Material der Umpolleiter (30) und/oder der Ausgleichsleiter (60) hoch leitfähig ist, vorzugsweise Kupfer, Aluminium, Silber, Gold oder eine Legierung derselben enthält, und vorzugsweise identisch dem Material ist, das die Barberpole-Struktur (16) bildet.

15. Magnetfeldsensorvorrichtung nach einem der vorangegangenen Ansprüche, **gekennzeichnet durch** zwei oder mehr elektrisch getrennte Umpolleiter (30-1, 30-2), von denen jeder für die unabhängige Umpolung des magnetischen Zustands mindestens eines Magnetfeldsensorelements (10) eines Brückenwiderstands (20) vorgesehen ist.

## Revendications

1. Dispositif sensible au champ magnétique (50) comprenant plusieurs couches fonctionnellement différentes (38, 60, 70), parmi lesquelles une couche formant pont de Wheatstone (70) qui comprend au moins deux résistances (20) d'un pont de Wheatstone (18), chaque résistance (20) comprenant au moins un élément sensible au champ magnétique (10) sous la forme d'une sous-résistance (22), et une couche de conducteur de basculement (38) qui comprend au moins un conducteur de basculement (30) destiné à basculer l'état de magnétisation interne de chaque élément sensible au champ magnétique (10), **caractérisé en ce que** ledit conducteur de basculement (30) comprend une pluralité de bandes de conducteur (32) disposées sur au moins deux sous-couches de conducteur de basculement différentes (38-1, 38-2) de ladite couche de conducteur de basculement (38) et couplées électriquement entre elles par des traversées.

2. Dispositif sensible au champ magnétique selon la revendication 1, **caractérisé par** un agencement constitué d'un premier groupe de bandes de conducteur (32, 34) destiné à produire un champ de basculement magnétique d'un élément sensible au champ magnétique associé (10) et disposé sur une première sous-couche de conducteur de basculement (38-1) opposée à un côté de la couche formant pont de Wheatstone (70), et d'au moins un deuxième groupe de bandes de conducteur (32, 36) destiné à assurer une connexion électrique dudit premier groupe de bandes de conducteur (34) et disposé sur au moins une deuxième sous-couche de conducteur de basculement (38-2).

3. Dispositif sensible au champ magnétique selon la revendication 2, **caractérisé en ce que** ledit premier groupe de bandes de conducteur (32, 34) est orienté essentiellement perpendiculairement par rapport à un alignement longitudinal dudit élément sensible au champ magnétique (10), et ledit deuxième groupe de bandes de conducteur (32, 36) est orienté essentiellement parallèlement par rapport audit alignement longitudinal dudit élément sensible au champ magnétique (10).

4. Dispositif sensible au champ magnétique selon la revendication 2 ou 3, **caractérisé en ce que** ledit premier groupe de bandes de conducteur (32, 34) comprend un agencement interdigital constitué desdites bandes de conducteur orientées perpendiculairement (34) pour produire un champ de basculement magnétique pour une partie centrale (80) dudit élément sensible au champ magnétique (10), et des bandes de conducteur perpendiculaires (34) pour produire un champ de basculement magnétique pour des parties d'extrémité (82) dudit élément sensible au champ magnétique (10).

5. Dispositif sensible au champ magnétique selon l'une quelconque des revendications précédentes, **caractérisé en ce que** ledit premier groupe de bandes de conducteur (34) est conçu et disposé de façon à pouvoir produire un champ de basculement magnétique accru au niveau des deux parties d'extrémité (82) de chaque élément sensible au champ magnétique (10) par rapport à un champ de basculement magnétique produit pour une partie centrale (80) dudit élément sensible au champ magnétique (10).

6. Dispositif sensible au champ magnétique selon l'une quelconque des revendications 2 à 5, **caractérisé en ce que** au moins une bande de conducteur dudit premier groupe de bandes de conducteur (32, 34) comprend au moins un élément de distribution de courant (44) conçu pour assurer une distribution de courant, de telle façon qu'un champ de basculement magnétique homogène puisse être excité dans une partie centrale (80) d'un élément sensible au champ magnétique (10), de préférence un profil de conductance (54) ou une zone non conductrice (56) de la bande de conducteur (32, 34), en particulier une cavité (58), ladite bande de conducteur (32, 34) étant de préférence adaptée pour basculer l'état de magnétisation interne de la partie centrale (80) dudit élément sensible au champ magnétique (10).

7. Dispositif sensible au champ magnétique selon l'une quelconque des revendications précédentes, **caractérisé en ce que** ladite résistance (20) comprend au moins deux éléments sensibles au champ magnétique (10) sous la forme de sous-résistances (22), chaque élément sensible au champ magnétique (10) comprenant une structure à lamelles inclinées (16) présentant un alignement incliné positif ou négatif (26, 28) en fonction de sa disposition par rapport à une direction du flux de courant de la bande de conducteur perpendiculaire associée (34) du conducteur de basculement (30).

8. Dispositif sensible au champ magnétique selon la revendication 7, **caractérisé par** un agencement interdigital (24) de sous-résistances (22) desdites au moins deux résistances (20) sur ladite couche formant pont de Wheatstone (70).

9. Dispositif sensible au champ magnétique selon l'une quelconque des revendications précédentes, **caractérisé par** une forme effilée, de préférence une forme elliptique, des deux parties d'extrémité longitudinales (82) dudit élément sensible au champ magnétique (10).

10. Dispositif sensible au champ magnétique selon l'une quelconque des revendications précédentes, **caractérisé en ce que** lesdites résistances de pont (20) sont disposées sur une couche formant pont de Wheatstone (70) en dessous de ladite première sous-couche de conducteur de basculement (38-1) et/ou à l'intérieur de ladite deuxième sous-couche de conducteur de basculement (38-2).

11. Dispositif sensible au champ magnétique selon l'une quelconque des revendications précédentes, **caractérisé par** un conducteur de compensation (60) destiné à générer un champ de compensation magnétique pour compenser un champ magnétique externe, ledit conducteur de compensation (60) étant disposé sur au moins une couche de conducteur de compensation (62), de préférence au-dessus de ladite couche formant pont de Wheatstone (70) et à côté de et/ou en décalage avec ladite couche de conducteur de basculement (38).

12. Dispositif sensible au champ magnétique selon la revendication 11, **caractérisé en ce que** ledit conducteur de compensation (60) comprend plusieurs bandes de conducteur (32) qui sont disposées sur au moins deux sous-couches de conducteur de compensation différentes (62-1, 62-2) de ladite couche de conducteur de compensation (62) et qui sont couplées électriquement entre elles par des traversées, de sorte qu'un premier groupe de bandes de conducteur de compensation (66) destiné à produire un champ de compensation magnétique est disposé sur ladite première sous-couche de conducteur de compensation (62-1) et qu'un deuxième groupe de bandes de conducteur de compensation (68) destiné à assurer une connexion électrique dudit premier groupe de bandes de conducteur de compensation (66) est disposé sur ladite deuxième sous-couche de conducteur de compensation (62-2), ledit premier groupe de bandes de conducteur de compensation (66) étant agencé au-dessus et à côté de ladite couche formant pont de Wheatstone (70) et en dessous de ladite première sous-couche de conducteur de basculement (38-1).

13. Dispositif sensible au champ magnétique selon l'une quelconque des revendications précédentes, **caractérisé en ce que** au moins une partie dudit conducteur de basculement (30) et/ou dudit conducteur de compensation (60) est agencée essentiellement en forme de U, en forme de spirale et/ou en forme de méandre.

14. Dispositif sensible au champ magnétique selon l'une quelconque des revendications précédentes, **caractérisé en ce que** le matériau dudit conducteur de basculement (30) et/ou dudit conducteur de compensation (60) est hautement conducteur, étant de préférence constitué de cuivre, d'aluminium, d'argent, d'or ou d'un alliage de ces matières, et est de préférence identique au matériau formant la structure à lamelles inclinées (16).

15. Dispositif sensible au champ magnétique selon l'une quelconque des revendications précédentes, **caractérisé par** deux ou plusieurs conducteurs de basculement électriquement séparés (30-1, 30-2), chacun étant conçu pour basculer indépendamment un état de magnétisation d'au moins un élément sensible au champ magnétique (10) d'une résistance de pont (20).
